# EUROPÄISCHE PATENTANMELDUNG

(11) **EP 2 750 488 A1**
(43) Veröffentlichungstag der Anmeldung: **02.07.2014**
(21) Anmeldenummer: 12008664.0
(22) Anmeldetag: 28.12.2012
(51) Int. Cl.: H05K 1/03, H05K 3/10, H05K 3/24, H05K 3/12

(54) **Verfahren zum Drucken von dünnen Metallschichten in einem Keramikschichtaufbau und diesen beinhaltende elektronische Bauteile**

(71) Anmelder: Heraeus Precious Metals GmbH & Co. KG, 63450 Hanau (DE)
(72) Erfinder: Flick, Stefan, 61350 Bad Homburg (DE); Fuchs, Dr. Herbert, 63549 Ronneburg (DE); Modes, Christina, 60439 Frankfurt (DE); Timter, Kerstin, 63607 Wächtersbach-Aufenau (DE)
(74) Vertreter: Brand, Normen

(57) **Zusammenfassung**

Die vorliegende Erfindung betrifft allgemein ein Verfahren zur Herstellung eines Schichtaufbaus (1), beinhaltend die Schritte:
a) Bereitstellen einer Keramikschicht (2) mit einer die Keramikschicht (2) mindestens teilweise überlagernden ersten Metallschicht (3);
b) mindestens teilweises Überlagern der ersten Metallschicht (3) mit einer weiteren Metallschicht (4), beinhaltend mindestens ein Metall der VIII. Nebengruppe;
c) gegebenenfalls mindestens teilweises Überlagern der ersten Metall-Schicht (3) mit einer zusätzlichen Metallschicht (5), beinhaltend mindestens ein Metall der VIII. Nebengruppe;
d) mindestens teilweises Überlagern der weiteren Metallschicht (4) oder der zusätzlichen Metallschicht (5) mit einer äußeren Schicht (6);

wobei das Überlagern in mindestens einem der Schritte b) bis d) durch Drucken mittels einer flüssigen Druckmasse (7, 8, 9) erfolgt, wobei die flüssige Druckmasse (7, 8, 9) eine metallorganische Verbindung in einer Menge in einem Bereich von 5 bis 50 Gew.-%, jeweils bezogen auf die Druckmasse (7, 8, 9) beinhaltet

## Beschreibung

Die vorliegende Erfindung betrifft allgemein ein Verfahren zur Herstellung eines Schichtaufbaus, vorzugsweise einen Schichtverbund, durch Bereitstellen einer Keramikschicht mit einer die Keramikschicht mindestens teilweise überlagernden ersten Metallschicht; mindestens teilweises Überlagern der ersten Metallschicht mit einer weiteren Metallschicht, beinhaltend mindestens ein Metall der VIII. Nebengruppe; ggf. mindestens teilweises Überlagern der ersten Metallschicht mit einer zusätzlichen Metallschicht, beinhaltend mindestens ein Metall der VIII. Nebengruppe; mindestens teilweises Überlagern der weiteren Metallschicht oder der zusätzlichen Metallschicht mit einer äußeren Schicht; wobei das Überlagern in mindestens einem der Schritte b) bis d) durch Drucken mittels einer flüssigen Druckmasse erfolgt, wobei die flüssige Druckmasse eine metallorganische Verbindung in einer Menge in einem Bereich von 5 bis 50 Gew.-% bezogen auf die Druckmasse beinhaltet.

Weiter betrifft die vorliegende Erfindung einen Schichtaufbau, vorzugsweise einen Schichtverbund, beinhaltend eine Keramikschicht sowie mindestens eine Metallschichtengruppe mit einer Schichtabfolge i. eine erste Metallschicht, ii. eine weitere Metallschicht, iii. gegebenenfalls eine zusätzliche Metallschicht, iv. eine äußere Schicht. Zusätzlich betrifft die vorliegende Erfindung mindestens einen Schichtaufbauvorläufer mit besonderen Eigenschaften, erhältlich nach unterschiedlichen Ausgestaltungen des Verfahrens zur Herstellung eines Schichtaufbaus. Weiterhin betrifft die vorliegende Erfindung einen Schichtaufbau mit besonderen Eigenschaften sowie ein elektronisches Bauteil beinhaltend einen integrierten Schaltkreis und einen Schichtaufbau. Darüber hinaus betrifft die vorliegende Erfindung ein Fahrzeug beinhalten das elektronische Bauteil. Zusätzlich betrifft die vorliegende Erfindung ein Kit beinhaltend i. eine erste Paste, beinhaltend mindestens zu einem Teil ein erstes Metall; ii. eine zweite Paste beinhaltend mindestens zu einem Teil ein Metall der VIII. Nebengruppe; iii. eine dritte Paste, beinhaltend mindestens zu einem Teil Gold.

Bei der Herstellung von Leiterplatten werden häufig aufwendige Maskierungs- und Ätzschritte verwendet, um elektrisch leitende Strukturen auf die Leiterplatte aufzubringen. Heutzutage werden die Komponenten, die auf der Leiterplatte miteinander verbunden werden sollen, immer anspruchsvoller und komplexer, was insbesondere für integrierte Schaltkreise gilt. Deshalb werden Methoden benötigt, gut leitende Verbindungen zwischen den Komponenten, wie beispielsweise der Leiterplatte und dem integrierten Schaltkreis (IC), auf möglichst kurzem Wege, bereitstellen zu können. Dabei ist es vor allem anspruchsvoll, die leitenden Strukturen mit wenig Aufwand möglichst nur an den wichtigen Positionen zu platzieren. Ein Problem, das bei der Kontaktierung von integrierten Schaltkreisen mit anderen Bauteilen auftritt ist, eine Struktur bereitzustellen, die die Kontaktierung des IC's ermöglicht, aber andererseits eine Isolierung zu dem Rest des Substrats, wie beispielsweise einer Leiterplatte zu gewährleisten. Dabei muss eine mechanisch belastbare Verbindung mit den anderen Komponenten bereitgestellt werden können. Diese Verbindungsstrukturen, auch Pads genannt, sollten möglichst klein, aber gut zugänglich für eine Kontaktierung sein. Um eine ausreichende elektrische Kontaktierung zu ermöglichen werden häufig Metalle als Oberfläche gewählt. Dabei sind die Metalle häufig nur schwierig in Lösung zu bringen und es bedarf oft lithographischer und/oder galvanischer Verfahren, um die Metalle strukturiert verarbeiten zu können.

Als leitende Oberfläche, die zur Herstellung von elektrischen Verbindungen zwischen elektrischen Bauteilen benutzt wird, wird häufig eine Silberschicht verwendet. Beim Anbinden weiterer metallhaltiger Schichten an die Silberschicht, dem sogenannten "Bonden", direkt auf eine Silberleitschicht, kann es infolge von Diffusionsprozessen zur Versprödung des Bondkontaktes und damit zu einer schlechten Haftung der metallhaltigen Schichten und zum Bruch der Verbindung dieser kommen. Damit dennoch eine dauerhafte Verbindung zwischen einer Silberschicht und einer weiteren metallhaltigen Schicht hergestellt werden kann, ist es üblich, eine zusätzliche Sperrschicht aus einem Übergangsmetall und ggf. eine weitere, bondbare Schicht aus Edelmetall aufzubringen. Die Sperrschicht soll dabei die zwischen den Edelmetallschichten stattfindenden Diffusionsprozesse unterbinden und die Haftung verbessern. Das Aufbringen einer zusätzlichen Edelmetallschicht kann diesen Effekt noch unterstützen. Dieser Schichtaufbau wird nach dem Stand der Technik durch galvanische Abscheidung der entsprechenden Metalle aus Lösung bewerkstelligt (dem ENEPIG-Verfahren das für Electroless Nickel Electroless Palladium Immersion Gold steht). Die galvanische Abscheidung hat jedoch auch erhebliche Nachteile. Es werden verhältnismäßig große Apparaturen und große Mengen an metallhaltigen Lösungen eingesetzt, deren Handhabung und Entsorgung die Umwelt Risiken und großen Belastungen aussetzt. Die Bauteile werden dabei in den galvanischen Bädern verschiedenen Chemikalien ausgesetzt, die unerwünschte Effekte zur Folge haben können. So kann es durch die Diffusion von Badbestandteilen (z.B. Säuren, Salze, Stabilisatoren etc.) in das Substrat (Al₂O₃) und die Metallschichten zu einer Verschlechterung der Haltbarkeit der Schichtstrukturen kommen. Aus den Leitschichten können Bestandteile der Leitschichten (z.B. Haftvermittler) in die Galvanikbäder eluiert werden, wo sie als Verunreinigungen den Abscheideprozess verschlechtern. Die Bäder müssen deshalb häufig ausgetauscht werden und sorgen so für große Mengen an schwermetallhaltigen Abfällen.

In der WO2007140463 A2 wird beispielsweise ein Tintenstrahl-Prozess beschrieben, um lötfähige, leitende Anschlüsse, in Form eines Pads, auf einer Leiterplatte, auch Platine genannt, bereitzustellen. Hierzu werden abwechselnd eine Silber enthaltende Tinte und eine Nickel enthaltende Tinte auf ein Substrat gedruckt. Dabei sind das Silber und das Nickel in Form von Nanopartikel in der Tinte enthalten, um durch Erhitzen der aufgebrachten Tinte eine Metallschicht auf dem Untergrund der Leiterplatte entstehen zu lassen. Bei dieser Methode sind große Mengen von speziellen Lösungsmitteln notwendig, um die Metallpartikel dispergieren zu können

Allgemein liegt eine Aufgabe der vorliegenden Erfindung darin, die sich aus dem Stand der Technik ergebenden Nachteile zumindest teilweise zu beseitigen.

Zudem besteht eine Aufgabe darin, ein einfaches und schnelles Verfahren zur Herstellung eines Schichtaufbaus mit mindestens drei Metallschichten bereitzustellen.

Eine weitere Aufgabe besteht darin, ein Verfahren zur Herstellung eines Schichtaufbaus mit mindestens drei Metallschichten bereitzustellen, das kostengünstig und effizient ist.

Wiederum besteht eine Aufgabe darin ein Verfahren zur Herstellung eines Schichtaufbaus mit mindestens drei Metallschichten bereitzustellen, das es ermöglicht feinstrukturierte und möglichst dünne Metallschichten zu generieren.

Weiterhin besteht eine Aufgabe darin, ein Verfahren zur Herstellung eines Schichtaufbaus mit mindestens drei Metallschichten bereitzustellen, bei dem möglichst wenig metallhaltige Abfälle generiert werden.

Es besteht ferner eine Aufgabe darin, ein elektronisches Bauteil bereitzustellen, das einfach und kostengünstig herstellbar ist.

Einen Beitrag zur Lösung mindestens einer der eingangs genannten Aufgaben leisten die Gegenstände der Kategorie bildenden Ansprüche. Die Gegenstände der von den Kategorie bildenden Ansprüchen abhängigen Unteransprüche stellen bevorzugte Ausgestaltungen dieses Lösungsbeitrages dar.

Einen Beitrag zur Lösung mindestens einer der vorstehenden Aufgaben leistet ein Verfahren zur Herstellung eines Schichtaufbaus, beinhaltend die Schritte:
a) Bereitstellen einer Keramikschicht mit einer die Keramikschicht mindestens teilweise überlagernden ersten Metallschicht;
b) mindestens teilweises Überlagern der ersten Metall-Schicht mit einer weiteren Metallschicht, beinhaltend mindestens ein Metall der VIII. Nebengruppe;
c) gegebenenfalls mindestens teilweises Überlagern der ersten Metall-Schicht mit einer zusätzlichen Metallschicht, beinhaltend mindestens ein Metall der VIII. Nebengruppe
d) mindestens teilweises Überlagern der weiteren Metallschicht oder der zusätzlichen Metallschicht mit einer äußeren Schicht, beinhaltend mindestens ein Metall ausgewählt aus der Gruppe bestehend aus Palladium, Platin, Ruthenium, Rhodium, Silber und Gold oder mindestens zwei davon;
wobei das Überlagern in mindestens einem der Schritte b) bis d) durch Drucken mittels einer flüssigen Druckmasse erfolgt, wobei die flüssige Druckmasse eine metallorganische Verbindung in einer Menge in einem Bereich von 5 bis 50 Gew.-%, bevorzugt in einem Bereich von 10 bis 40 Gew.-%, jeweils bezogen auf die Druckmasse beinhaltet.

Die Schichten können direkt oder indirekt einander überlagern. Bevorzugt ist die Keramikschicht aus Schritt a) direkt mit der ersten Metallschicht aus Schritt a) verbunden. Die Metallschicht aus Schritt a) ist bevorzugt direkt mit der weiteren Metallschicht aus Schritt b) verbunden. Die weitere Metallschicht ist bevorzugt direkt mit der zusätzlichen Metallschicht verbunden. Die zusätzliche oder die weitere Metallschicht ist bevorzugt direkt mit der äußeren Schicht verbunden.

Das Bereitstellen der Keramikschicht kann auf jede dem Fachmann bekannte Art vollzogen werden, die es ermöglicht, mindestens einen Teil der Keramikschicht mit einer weiteren Schicht zu überlagern. Das Bereitstellen der Keramikschicht kann beispielsweise ausgewählt sein aus der Gruppe bestehend aus einem Legen, einem Entrollen, einem Entfalten, einem Vereinzeln und einem Stellen oder einer Kombination hieraus. Die Keramikschicht weist bevorzugt eine flächige Geometrie auf. Die Keramikschicht weist bevorzugt eine Dicke in einem Bereich von 1 µm bis 1 cm, oder bevorzugt in einem Bereich von 10 µm bis 1 mm, oder besonders bevorzugt in einem Bereich von 50 µm bis 0,1 mm. Die Keramikschicht weist bevorzugt eine Fläche, gebildet von der Breite und Tiefe der Keramikschicht, in einem Bereich von 0,1 mm² bis 50 m², oder bevorzugt in einem Bereich von 1 mm² bis 5 m² , oder bevorzugt in einem Bereich von 10 mm² bis 1 m² auf. Der Bereich in dem die Keramikschicht bevorzugt von einer weiteren Schicht, besonders bevorzugt von der ersten Metallschicht überlagert wird, stellt bevorzugt einen Teil der Gesamtfläche der Keramikschicht in einem Bereich von 10 bis 100 %, oder bevorzugt in einem Bereich von 20 bis 100 %, oder bevorzugt in einem Bereich von 30 bis 100 % dar. Die Keramikschicht kann aus jedem keramischen Material hergestellt sein, das dazu geeignet ist mit Metallschichten überlagert zu werden. Bevorzugt weist die Keramikschicht ein Material auf, das einer Temperatur bis mindestens 500 °C ohne chemische oder physikalische Änderung standhält. Bevorzugt beinhaltet die Keramikschicht ein Material ausgewählt aus der Gruppe bestehend aus einem BeO, einem ZrO₂ einem Fe₂O₃, einem Al₂O₃, beispielsweise einem glasierten Al₂O₃, AlN, einem Siliciumcarbid, einem Siliciumoxid, beispielsweise einem Quarzglas, einem Silicat, wie Feldspat, einem Glas, beispielsweise einem Borosilikatglas, und einem mit Dielektrikum beschichteten Metall oder einer Kombination von mindestens zwei hiervon.

Die erste Metallschicht überlagert die Keramikschicht mindestens teilweise, bevorzugt in einem Bereich von 10 bis 100 %, oder bevorzugt in einem Bereich von 20 bis 100 %, oder bevorzugt in einem Bereich von 30 bis 100 %, bezogen auf die Gesamtfläche der Keramikschicht. Die erste Metallschicht kann direkt oder indirekt auf eine und/oder beiden Seiten der Keramikschicht aufgebracht sein. Bevorzugt ist die erste Metallschicht direkt auf die Keramikschicht folgend. Die erste Metallschicht beinhaltet bevorzugt ein Metall ausgewählt aus der Gruppe bestehend aus Silber und Kupfer.

Die erste Metallschicht wird mindestens teilweise überlagert von einer weiteren Metallschicht, wobei die weitere Metallschicht mindestens ein Metall der VIII. Nebengruppe aufweist. Unter einem Metall der VIII. Nebengruppe wird gemäß der Erfindung ein Metall ausgewählt aus der Gruppe bestehend aus Scandium (Sc), Titan (Ti), Vanadium (V), Chrom (Cr), Mangan (Mn), Eisen (Fe), Cobalt (Co), Nickel (Ni), Kupfer (Cu), Zink (Zn), Yttrium (Y), Zirkonium (Zr), Niob (Nb), Molybdän (Mo), Technetium (Tc), Ruthenium (Ru), Rhodium (Rh), Palladium (Pd), Silber (Ag), Cadmium (Cd), Lanthan (La), Hafnium (Hf), Tantal (Ta), Wolfram (W), Rhenium (Re), Osmium (Os), Iridium (Ir), Platin (Pt), Gold (Au), Quecksilber (Hg), Actinium (Ac), Rutherfordium (Rf), Dysprosium (Db), Seaborgium (Sg), Bohrium (Bh), Hassium (Hs), Meitnerium (Mt), Darmstadtium (Ds), Roentgenium (Rg), Copernicium (Cn) verstanden. Bevorzugt ist das Metall der VIII. Nebengruppe ausgewählt aus der Gruppe bestehend aus Scandium (Sc), Titan (Ti), Vanadium (V), Chrom (Cr), Mangan (Mn), Eisen (Fe), Cobalt (Co), Nickel (Ni), Kupfer (Cu), Zink (Zn), Yttrium (Y), Zirkonium (Zr), Niob (Nb), Molybdän (Mo), Technetium (Tc), Ruthenium (Ru), Rhodium (Rh), Palladium (Pd), Silber (Ag), Cadmium (Cd), Lanthan (La), Hafnium (Hf), Tantal (Ta), Wolfram (W), Rhenium (Re), Osmium (Os), Iridium (Ir), Platin (Pt), Gold (Au). Bevorzugt weist die weitere Metallschicht das mindestens eine Metall der VIII. Nebengruppe in einer Menge in einem Bereich von 5 bis 100 Gew.-%, oder bevorzugt in einem Bereich von 10 bis 100 Gew.-%, oder bevorzugt in einem Bereich von 20 bis 100 Gew.-%, jeweils bezogen auf die Gesamtmasse der weiteren Metallschicht auf. Die weitere Metallschicht überlagert die erste Metallschicht bevorzugt in einem Bereich von 10 bis 100 %, oder bevorzugt in einem Bereich von 20 bis 100 %, oder bevorzugt in einem Bereich von 30 bis 100 %, bezogen auf die Gesamtfläche der ersten Metallschicht. Als Gesamtfläche ist bevorzugt die zugängliche Fläche der ersten Metallschicht zu verstehen, die nach der Überlagerung der Keramikschicht mit der ersten Metallschicht nicht mit der Keramikschicht in direkter oder indirekter Verbindung steht.

Die erste Metallschicht kann gegebenenfalls von einer zusätzlichen Metallschicht überlagert werden. Bevorzugt wird die weitere Metallschicht, von der zusätzlichen Metallschicht überlagert. Die zusätzliche Metallschicht beinhaltet mindestens ein Metall der VIII. Nebengruppe. Bevorzugt weist die zusätzliche Metallschicht das mindestens eine Metall der VIII. Nebengruppe in einer Menge in einem Bereich von 5 bis 100 Gew.-%, oder bevorzugt in einem Bereich von 10 bis 100 Gew.-%, oder bevorzugt in einem Bereich von 20 bis 100 Gew.-%, jeweils bezogen auf die Gesamtmasse der zusätzlichen Metallschicht auf. Die zusätzliche Metallschicht überlagert die weitere Metallschicht bevorzugt in einem Bereich von 10 bis 100 %, oder bevorzugt in einem Bereich von 20 bis 100 %, oder bevorzugt in einem Bereich von 30 bis 100 %, bezogen auf die Gesamtfläche der weiteren Metallschicht. Als Gesamtfläche der weiteren Metallschicht ist bevorzugt die zugängliche Fläche der weiteren Metallschicht gemeint, die nach der Überlagerung der ersten Metallschicht mit der weiteren Metallschicht nicht mit der ersten Metallschicht in direkter oder indirekter Verbindung steht.

Erfindungsgemäß wird die weitere Metallschicht oder die zusätzliche Metallschicht mit einer äußeren Schicht überlagert. Die äußere Schicht überlagert die weitere oder die zusätzliche Metallschicht bevorzugt in einem Bereich von 10 bis 100 %, oder bevorzugt in einem Bereich von 20 bis 100 %, oder bevorzugt in einem Bereich von 30 bis 100 %, bezogen auf die Gesamtfläche der weiteren beziehungsweise der zusätzlichen Metallschicht. Die äußere Schicht überlagert entweder die weitere Metallschicht oder, wenn der Schichtaufbau auch eine zusätzliche Metallschicht aufweist, die zusätzliche Metallschicht. Als Gesamtfläche der weiteren oder der zusätzlichen Metallschicht ist bevorzugt die zugängliche Fläche der jeweiligen Metallschicht gemeint. Die äußere Schicht beinhaltet mindestens ein Metall ausgewählt aus der Gruppe bestehend aus Palladium, Platin, Ruthenium, Rhodium, Silber und Gold oder eine Mischung aus mindestens zwei davon, bevorzugt in einem Bereich von 1 bis 100 Gew.-%, oder bevorzugt in einem Bereich von 30 bis 100 Gew.-%, oder bevorzugt in einem Bereich von 70 bis 100 Gew.-% bezogen auf die äußere Schicht.

Weiterhin können die erste Metallschicht, die weitere Metallschicht, die zusätzliche Metallschicht oder die äußere Schicht weitere Bestandteile beinhalten. Die Bestandteile können ausgewählt sein aus der Gruppe bestehend aus: einem zusätzlichen Metall und einer anorganischen Verbindung oder einer Mischung davon. Bevorzugt ist das zusätzliche Metall ausgewählt aus der Gruppe bestehend aus einem Übergangsmetall oder einem Metall ausgewählt aus einer Periode benachbart zu den Übergangsmetallen. Bevorzugt ist das zusätzliche Metall ausgewählt aus der Gruppe bestehend aus Aluminium, Zink, Silber, Gold, Kupfer, Platin, Palladium, Nickel, Iridium, Rhodium, Kobalt, Osmium, Ruthenium, Eisen, Mangan, Rhenium, Molybdän, Chrom, Wolfram, Vanadium, Niob, Titan, Zirkonium und Hafnium oder einer Mischung von mindestens zwei davon. Das zusätzliche Metall entspricht dabei bevorzugt keinem der Metalle, die für die weitere Metallschicht aus der VIII. Nebengruppe ausgewählt wurden. Die erste Metallschicht, die weitere Metallschicht, die zusätzliche Metallschicht oder die äußere Schicht kann das zusätzliche Metall jeweils in einem Bereich von 0,001 bis 25 Gew.-%, bevorzugt in einem Bereich von 0,01 bis 20 Gew.-% oder bevorzugt in einem Bereich von 0,05 bis 15 Gew.-% bezogen jeweils auf die erste Metallschicht, die weitere Metallschicht, die zusätzliche Metallschicht oder die äußere Schicht beinhalten.

Die anorganische Verbindung ist bevorzugt ausgewählt aus der Gruppe bestehend aus einem Glas, einem gemahlenen Glas, einem Salz, einer Fritte und einer Keramik oder einer Mischung von mindestens zwei hiervon. Die anorganische Verbindung ist weiterhin bevorzugt ausgewählt aus der Gruppe bestehend aus einem Metallsalz, einem Ammoniumsalz, einem Silikat oder eine Mischung von mindestens zwei hiervon. Die anorganische Verbindung ist bevorzugt ausgewählt aus der Gruppe bestehend aus Siliciumdioxid, Quarzglas, Kalium-, Natrium- oder Magnesiumsulfat, Kalium-, Natrium oder Magnesiumphosphat, Kalium-, Natrium oder Magnesiumsulfat, Kalium-, Natrium- oder Magnesiumphosphat, Aluminiumoxid, Aluminiumchlorid, Aluminiumsulfat, Ammoniumchlorid, Ammoniumphosphat, Ammoniumsulfat, Ammoniumnitrat, einem Feldspat, einem Glimmer, einem Tonmineral, einem Granat oder einer Mischung aus mindestens zwei hiervon. Bevorzugt ist die anorganische Verbindung eine oxidische Verbindung, wie beispielsweise Siliciumdioxid.

Die erste Metallschicht, die weitere Metallschicht, die zusätzliche Metallschicht oder die äußere Schicht kann die anorganische Verbindung jeweils in einem Bereich von 0,001 bis 25 Gew.-%, bevorzugt in einem Bereich von 0,01 bis 20 Gew.-% oder bevorzugt in einem Bereich von 0,05 bis 15 Gew.-% bezogen jeweils auf die erste Metallschicht, die weitere Metallschicht, die zusätzliche Metallschicht oder die äußere Schicht beinhalten.

Das Überlagern der jeweiligen vorherigen Schicht in den Schritten b) bis d) kann jede Art von Überlagern einer Schicht mit einem weiteren Material sein, die der Fachmann für die Herstellung eines erfindungsgemäßen Schichtaufbaus auswählen würde. In einer bevorzugten Ausgestaltung des Verfahrens erfolgt das Überlagern der vorherigen Schicht, wie in Schritt b) der Silber-Schicht, in Schritt c) der zusätzlichen Metallschicht und in Schritt d) der weiteren Metallschicht durch einen Prozess, ausgewählt aus der Gruppe, bestehend aus Ablegen oder Tauchen oder einer Kombination davon. Bevorzugt wird beim Ablegen oder Tauchen ein Material, wie beispielsweise eine Flüssigkeit, eine Paste oder ein Pulver über die Schicht aus den Schritten b) bis d) mindestens teilweise gelagert. Das Material wird folgend als Druckmasse bezeichnet, auch wenn das Überlagern nicht zwingend über einen Druckprozess erfolgen muss. Unter Ablegen wird erfindungsgemäß verstanden, dass das zum Überlagern verwendete Material, bevorzugt auch Flüssigkeit oder Druckmasse genannt, mittels eines Hilfsmittels auf der zu überlagernden Oberfläche aufgebracht wird. Dies kann durch unterschiedliche Hilfsmittel geschehen. So kann die zum Überlagern verwendete Druckmasse auf die jeweilige Schicht durch eine Düse gesprüht, gespritzt oder durch eine Schlitzdüse abgelegt werden. Weitere Methoden sind das Vorhanggießen und das Spin-Coating. Alternativ oder zusätzlich kann zum Überlagern verwendete Druckmasse beispielsweise über eine Rolle oder Walze auf die Oberfläche appliziert bzw. gedruckt werden. Als Sprüh- bzw. Spritzverfahren sind beispielsweise das Mikro-Dosierung oder Ink-Jet Printing über eine Düse bekannt. Hierbei kann auf die zum Überlagern verwendete Druckmasse Druck ausgeübt werden oder die zum Überlagern verwendete Druckmasse wird einfach tropfend auf die Oberfläche durch die Düse appliziert. Als Druckverfahren kann bevorzugt ein Siebdruckverfahren angewendet werden. Beim Siebdruckverfahren wird ein Sieb, bestehend aus einem möglichst formstabilen Material, wie Holz; Metall, bevorzugt Stahl; einer Keramik oder einem Kunststoff mit einer ausgewählten Maschenweite auf das zu überlagernde oder über dem zu überlagernden Objekt, wie hier die verschiedenen Schichten, angeordnet. Auf dieses Sieb wird die zum Überlagern verwendete Druckmasse aufgebracht und mit einer Rakel durch die Maschen gedrückt. Dabei kann aufgrund eines Musters in dem Sieb an unterschiedlichen Stellen unterschiedlich viel, zum Überlagern verwendete Druckmasse aufgebracht werden. So kann durch die Geometrie und Anordnung der Maschen entweder ein gleichmäßiger Film der zum Überlagern verwendeten Druckmasse aufgebracht werden oder Bereiche mit keiner oder wenig zum Überlagern verwendeten Druckmasse mit Bereichen mit viel zum Überlagern verwendeten Druckmasse abwechseln. Bevorzugt wird ein gleichmäßiger Film der zum Überlagern verwendeten Druckmasse auf die Oberfläche übertragen. Die Siebmaschen können auch durch entsprechend aufgebrachte Materialien (Kopierschichten, Siebdruckschablonen) teilweise geschlossen sein, so dass die Druckmasse nur in definierten Bereichen mit offenen Maschen auf das Substrat übertragen wird, um so beispielsweise eine definierte Struktur wie ein Muster zu erhalten. Weiterhin können statt Sieben auch dünne Filme mit definierten Öffnungen (Stencil) zum Überlagern der Druckmasse verwendet werden. Alternativ kann das Tampondruckverfahren angewendet werden, das beispielsweise eine Druckmasse übertragende Oberfläche mit der zum Überlagern verwendeten strukturierten Druckmasse vorsieht, die auf die zu beschichtende Oberfläche gedrückt oder über sie gerollt wird.

Je nach Ausgestaltung der Düse bzw. Rolle oder Walze sowie der Viskosität und Polarität der zum Überlagern verwendeten Druckmasse, können unterschiedlich Dicke Schichten auf die gewünschte Oberfläche der vorherigen Schicht aufgebracht werden. Bevorzugt wird nach Überlagern der jeweiligen Schicht, die beim Überlagern aufgebrachte Schicht mit einer Dicke in einem Bereich von 0,5 bis 100 µm, bevorzugt in einem Bereich von 1 bis 50 µm, besonders bevorzugt in einem Bereich von 2 bis 30 µm appliziert. Die Dicke der beim Überlagern aufgebrachten Schicht wird im Folgenden Nassschichtdicke genannt. Die Nassschichtdicke ist abhängig von dem jeweiligen Material, das beim Überlagern aufgebracht wird. Die Nassschichtdicke wird direkt im Anschluss an den Schritt des Überlagerns gemessen.

Bei dem Tauchen wird beispielsweise die zu beschichtende Oberfläche durch ein Bad mit der zum Überlagern verwendeten Druckmasse gezogen. Alternativ kann die Oberfläche auch einfach in die zum Überlagern verwendeten Druckmasse eingetaucht und wieder herausgezogen werden, so wie dies beim Dip-Coating praktiziert wird. Durch mehrmaliges Tauchen können unterschiedliche Dicken der Beschichtung beim Überlagern erreicht werden. Außerdem ist die Dicke der Beschichtung abhängig von der Wahl der zum Überlagern verwendeten Druckmasse, wie oben bereits erwähnt. Auf diese Weise können Nassschichtdicken der jeweiligen Beschichtung beim Überlagern in einem Bereich zwischen von 0,5 bis 100 µm, bevorzugt in einem Bereich von 1 bis 50 µm, besonders bevorzugt in einem Bereich von 2 bis 30 µm erzielt werden. Es ist auch denkbar eine Kombination der Ableg- und Tauchverfahren vorzunehmen.

In einer Ausführungsform erfolgt das Aufbringen der zum Überlagern verwendeten Druckmasse durch eine über der jeweiligen Oberfläche der zu überlagernden Schicht vorgesehene Aufbringöffnung. Dabei ist die Aufbringöffnung mit der Oberfläche bevorzugt über die zum Überlagern verwendeten Druckmasse verbunden. Dieses Verfahren, auch als Mikro-Dosierung bekannt, hat die besondere Eigenschaft, dass hierdurch ermöglicht wird, auf einfache Weise unterschiedliche Dicken der überlagernden Beschichtung auf Objekte, wie hier der Oberfläche verschiedener Schichten, wie in Schritt b) der weiteren Schicht oder in Schritt c) der zusätzlichen Metallschicht oder in Schritt d) der äußeren Metallschicht, aufzubringen. Die Aufbringöffnung kann jede erdenkliche Form und Größe aufweisen. Es kann sich beispielsweise um eine Aufbringöffnung mit einer Form ausgewählt aus der Gruppe rund, oval, eckig und sternförmig oder Kombinationen hieraus handeln. Die Aufbringöffnung kann eine Fläche von 10 nm bis 1 mm, bevorzugt von 100 nm bis 0,5 mm, besonders bevorzugt von 100 nm bis 100 µm aufweisen. Bevorzugt wird die zum Überlagern verwendete Druckmasse, auch Flüssigkeit oder Paste genannt, mit Hilfe von einem Druck in einem Bereich von 2000 bis 10000 mbar, bevorzugt in einem Bereich von 2500 bis 5000 mbar, besonders bevorzugt in einem Bereich von 3000 bis 4000 mbar durch die Düse auf der Oberfläche appliziert. Durch die Verbindung der zum Überlagern verwendeten Druckmasse mit der Oberfläche der jeweiligen zu überlagernden Schicht beim Aufbringen der zum Überlagern verwendeten Druckmasse auf die Oberfläche, kann vermieden werden, dass es einen Abriss der zum Überlagern verwendeten Druckmasse auf der Oberfläche gibt. Dadurch kann erreicht werden, dass ein sehr homogener Film auf die Oberfläche appliziert werden kann.

Bevorzugt erfolgt das Überlagern in mindestens einem der Schritte b) bis d) mittels eines Siebdruckverfahrens. In einer bevorzugten Ausgestaltung des Verfahrens wird während des Druckens in den Schritten b) bis d) die Druckmasse durch ein Sieb aufgetragen wird. Das Sieb beinhaltet bevorzugt einen Rahmen aus Stahl oder Edelstahl. In dem Rahmen ist bevorzugt ein Gitter oder Sieb angeordnet, das ebenfalls bevorzugt aus Edelstahldrähten oder hochfesten synthetischen Fasern besteht.

Eine bevorzugte Ausgestaltung des Verfahrens ist, wobei das Sieb eine Maschenweite in einem Bereich von 1 bis 300 µm, bevorzugt in einem Bereich von 2 bis 200 µm, oder bevorzugt in einem Bereich von 3 bis 90 µm aufweist. Dies entspricht jeweils einer Maschenanzahl von ca. 70 bis 635 mesh, beziehungsweise von ca. 100 bis 500 mesh beziehungsweise von ca. 200 bis 400 mesh, wobei mesh der Einheit Maschendraht/Zoll bzw. Maschendraht/2,54 cm entspricht. Beim Überlagern in den Schritten b) bis d) mittels Siebdruck, kann als Rakel jede handelsübliche Rakel verwendet werden. Bevorzugt beinhaltet die Rakel einen Kunststoff. Bevorzugt weist die Rakel eine Rakelhärte in einem Bereich von 40 bis 80 Shore A auf. Die Druckmasse weist bevorzugt eine Viskosität in einem Bereich von 500 bi 50000 mPa, oder bevorzugt in einem Bereich von 1000 bis 50000 mPa, oder bevorzugt in einem Bereich von 5000 bis 50000 mPa auf.

Mindestens einer der Schritte b) bis d) erfolgt erfindungsgemäß durch ein Drucken mittels einer flüssigen Druckmasse. Die flüssige Druckmasse beinhaltet eine metallorganische Verbindung in einer Menge in einem Bereich von 5 bis 50 Gew.-%, bevorzugt in einem Bereich von 10 bis 40 Gew.-%, oder bevorzugt in einem Bereich von 15 bis 30 Gew.-% bezogen auf die Druckmasse.

Je nachdem für welchen Schritt b) bis d) des erfindungsgemäßen Verfahrens die Druckmasse beschrieben wird, wird die Druckmasse im Folgenden mit Druckmasse b), für die Druckmasse in Schritt b); Druckmasse c), für die Druckmasse in Schritt c); oder Druckmasse d) für die Druckmasse in Schritt d), benannt.

Die Druckmasse b) in Schritt b) beinhaltet zum Erhalt der weiteren Metallschicht bevorzugt eine metallorganische Verbindung in einer Menge in einem Bereich von 5 bis 50 %, bevorzugt in einem Bereich von 10 bis 40 % bezogen auf die Druckmasse. Weiterhin bevorzugt beinhaltet die metall-organische Verbindung mindestens ein Metall der VIII. Nebengruppe.

Die metallorganische Verbindung beinhaltet eine Metallkomponente und eine organische Komponente. Die Metallkomponente und die organische Komponente können über eine Bindung verbunden sein ausgewählt aus der Gruppe bestehend aus ionisch, koordinativ und kovalent oder einer Kombination aus mindestens zweien davon. Bevorzugt ist die Bindung zwischen der metallischen Komponente und der organischen Komponente eine ionische oder eine koordinative Bindung oder eine Kombination aus den beiden. Unter einer Kombination aus mindestens zwei Bindungstypen wird verstanden, dass die metallorganische Verbindung sowohl Moleküle mit ionischer Bindung und Moleküle mit koordinativer Bindung, oder Moleküle mit koordinativer und Moleküle mit kovalenter, oder Moleküle mit ionischer und Moleküle mit kovalenter Bindung, zwischen Metallkomponente und organischer Komponente der Moleküle beinhalten.

Die Metallkomponente der metallorganischen Verbindung ist bevorzugt ein Material, das befähigt ist, spätestens nach Erhitzen auf über 300 °C elektrischen Strom zu leiten. Es ist bevorzugt, dass die Metallkomponente der metallorganischen Verbindung ein Metall oder ein Halbleitermetall beinhaltet. Die Metallkomponente ist bevorzugt ausgewählt aus der Gruppe bestehend aus einem Alkalimetall, einem Erdalkalimetall, einem Lanthanoid, einem Actinoid, einem Übergangsmetall und einem Halbleitermetall oder einer Mischung aus mindestens zwei hiervon. Bevorzugt ist das Metall der Metallkomponente ein Übergangsmetall oder ein Metall ausgewählt aus einer Periode benachbart zu den Übergangsmetallen. Weiterhin bevorzugt ist das Metall der Metallkomponente ausgewählt aus der Gruppe bestehend aus Aluminium, Zink, Silber, Gold, Platin, Palladium, Ruthenium, Kupfer, Nickel, Kobalt, Chrom und Eisen oder einer Mischung aus mindestens zwei hiervon. Ebenso können Legierungen aus mindestens zwei der vorgenannten Metalle verwendet werden. Bevorzugt beinhaltet die Metallkomponente der metallorganischen Verbindung eine Mischung von zwei verschiedenen Metallen.

Die Metallkomponenten der metallorganischen Verbindungen in den Druckmassen b), c) und d) können sich unterscheiden. So ist es bevorzugt, dass die Metallkomponente der Druckmasse b) bevorzugt ein Metall beinhaltet ausgewählt aus der Gruppe bestehend aus Aluminium, Zink, Silber, Gold, Kupfer, Platin, Palladium, Nickel, Iridium, Rhodium, Kobalt, Osmium, Ruthenium, Eisen, Mangan, Rhenium, Molybdän, Chrom, Wolfram, Vanadium, Niob, Titan, Zirkonium und Hafnium oder mindestens zwei hiervon, wobei Silber, Kupfer, Nickel, Gold oder mindestens zwei davon besonders bevorzugt sind. Bevorzugt beinhaltet die Metallkomponente der metallorganischen Verbindung in der Druckmasse b) Nickel. Die Druckmasse b) beinhaltet oben genannte Metalle in Form einer metallorganischen Verbindung bevorzugt in einem Bereich von 0,3 bis 20 Gew.-%, bevorzugt in einem Bereich von 0,5 bis 15 Gew.-%, oder bevorzugt in einem Bereich von 1 bis 10 Gew,.-%. Weiterhin beinhaltet die Metallkomponente der metallorganischen Verbindung der Druckmasse b) metallorganische Verbindungen ausgewählt.

Weiterhin ist es bevorzugt, dass die Metallkomponente der metallorganischen Verbindung in der Druckmasse c) bevorzugt ein Metall beinhaltet ausgewählt aus der Gruppe bestehend aus Aluminium, Zink, Silber, Gold, Kupfer, Platin, Palladium, Nickel, Iridium, Rhodium, Kobalt, Osmium, Ruthenium, Eisen, Mangan, Rhenium, Molybdän, Chrom, Wolfram, Vanadium, Niob, Titan, Zirkonium und Hafnium oder mindestens zwei hiervon, wobei Palladium für sich oder in Kombination mit einem der vorstehenden Metalle besonders bevorzugt ist. Bevorzugt beinhaltet die Metallkomponente der metallorganischen Verbindung in der Druckmasse c) Palladium. Die Druckmasse c) beinhaltet bevorzugt die für die Druckmasse c) genannten Metalle in Form einer metallorganischen Verbindung bevorzugt in einem Bereich von 1 bis 20 Gew.-%, bevorzugt in einem Bereich von 2 bis 15 Gew.-%, oder bevorzugt in einem Bereich von 3 bis 10 Gew,.-%.

Weiterhin ist es bevorzugt, dass die Metallkomponente der Druckmasse d) bevorzugt ein Metall beinhaltet ausgewählt aus der Gruppe bestehend aus Aluminium, Zink, Silber, Gold, Kupfer, Platin, Palladium, Nickel, Iridium, Rhodium, Kobalt, Osmium, Ruthenium, Eisen, Mangan, Rhenium, Molybdän, Chrom, Wolfram, Vanadium, Niob, Titan, Zirkonium und Hafnium, oder mindestens zwei hiervon, wobei Rhodium, Gold oder mindestens zwei davon besonders bevorzugt sind. Bevorzugt beinhaltet die Metallkomponente der metallorganischen Verbindung in der Druckmasse d) Gold oder Rhodium oder beide. Die Druckmasse d) beinhaltet Gold oder Rhodium in Form von metallorganischen Verbindungen bevorzugt in einem Bereich von 1 bis 40 Gew.-%, bevorzugt in einem Bereich von 5 bis 30 Gew.-%, oder bevorzugt in einem Bereich von 9 bis 22 Gew,.-%. Weiterhin beinhaltet die Metallkomponente der metallorganischen Verbindung der Druckmasse d) Rhodium in einem Bereich von 0,0001 bis 1 Gew.-%.

Die organische Komponente der metallorganischen Verbindung beinhaltet bevorzugt ein Molekül mit mindestens einem, mindestens zwei oder mehr Kohlenstoffatomen, bevorzugt in einem Bereich von 2 bis 100, oder bevorzugt in einem Bereich von 4 bis 50, oder bevorzugt in einem Bereich von 5 bis 20 Kohlenstoffatomen. Es ist bevorzugt, dass die organische Komponente ein oder zwei oder mehr nichtmetallische von Kohlenstoff verschiedene Atome beinhaltet. Weiterhin ist bevorzugt, dass mindestens eines der mindestens einen nicht metallischen Atome mit der metallischen Komponente der organischen Verbindung mindestens koordinativ, bevorzugt ionisch oder koordinativ wechselwirken. Es kann zwischen mindestens einem nichtmetallischen Atom und der metallischen Komponente auch eine kovalente Bindung ausgebildet werden. Die nichtmetallischen Atome sind bevorzugt ausgewählt aus der Gruppe bestehend aus Sauerstoff, Schwefel, Stickstoff, Phosphor, Silicium, einem Halogen oder einer Mischung von mindestens zwei hiervon. Bevorzugt bildet das mindestens eine Kohlenstoffatom zusammen mit dem mindestens einen nichtmetallischen Atom in der organischen Komponente der metallorganischen Verbindung eine organische Verbindung aus.

In einer bevorzugten Ausgestaltung des Verfahrens weist die metallorganische Verbindung eine organische Komponente ausgesucht aus der Gruppe bestehend aus einem Carbonat, einem Oxalat, einem Ester, einem Carboxylat, einem Halogencarboxylat, einem Hydroxycarboxylat, einem Acetonat, einem Ketonat, einem Phosphat, einem Phosphit, einem Phosphid, einem Phosphan, einem Sulfonat und einem Sulforesinat oder einer Mischung aus mindestens zwei davon auf. Bevorzugt ist die organische Komponente ausgewählt aus der Gruppe bestehend aus Acetat, Proprionat, Butanoat, Ethylbutyrat, Pivalat, Cyclohexanebutyrat, Acetylacetonat, Ethylhexanoat, Hydroxypropionat, Trifluoracetat, Hexafluor-2,4-pentadionat; Neodecanoate, Methansulfonat, Ethansulfonat, Propansulfonat, Trifluormethansulfonat, p-Toluolsulfonat, Benzolsulfonate, geschwefelte ungesättigte Natur- und/oder Syntheseharze, beispielsweise Terpentin, Kolophonium und Kopaivabalsam, oder eine Mischung aus mindestens zwei hiervon.

In einer bevorzugten Ausgestaltung des Verfahrens beinhaltet die erste Metallschicht ein Metall ausgewählt aus der Gruppe bestehend aus Silber und Kupfer oder einer Mischung daraus.

Das Verfahren nach einem der vorhergehenden Ansprüche, wobei die Druckmasse als Massenkomponenten neben
i. der metallorganischen Verbindung mindestens eine weitere Komponente ausgewählt aus der Gruppe bestehend aus
ii. einem Lösemittel,
iii. einem organischen Additiv, und
iv. einem anorganischen Additiv,
oder mindestens zweien davon,
beinhaltet.

Das Lösemittel ist bevorzugt ausgewählt aus der Gruppe bestehend aus Wasser oder einer organischen Verbindung. Die organische Verbindung ist bevorzugt ausgewählt aus der Gruppe bestehend aus einem Alkohol, einem Aldehyd, einem Keton, einer Carbonsäure, einem Erdöldestillat, einem Amin, einem Ester, einem Ether, einem Kohlenwasserstoff, einem Sulfoxid, einem Sulfon, einem Sulfonat, einem Lacton, einem Lactam, einer Nitroverbindung, einem Nitril, einem Polymer und einem Öl oder einer Mischung von mindestens zwei davon. Weiterhin ist es bevorzugt, dass die organische Verbindung ausgewählt ist aus der Gruppe bestehend aus einem aliphatischen Alkohol, einem aromatischen Alkohol, einem ungesättigten Alkohol, einem aliphatischen Aldehyd, einem aromatischen Aldehyd, einem ungesättigten Aldehyd, aliphatischen Keton, einem aromatischen Keton, einem ungesättigten Keton, einer aliphatischen Carbonsäure, einer aromatischen Carbonsäure, einer ungesättigten Carbonsäure, einer Bicarbonsäure, einem Benzin, einem aliphatischen Kohlenwasserstoff, einem aromatischen Kohlenwasserstoff, einem verzweigten Kohlenwasserstoff, einem ringförmigen Kohlenwasserstoff, einem halogenierten Kohlenwasserstoff, einem Glycolether, einem Glycoletheracetat, einem aromatischen Polymer, einem ungesättigten Polymer, einem ätherischen Öl, oder einer Mischung von mindestens zwei davon.

Es ist weiterhin bevorzugt, dass das organische Additiv ausgewählt ist aus der Gruppe bestehend aus Methanol, Ethanol, n-Butanol, n-Propanol, Formaldehyd, Acetaldehyd, Benzaldehyd, Furfural, Aceton, Acetophenon, Chalkon, Ameisensäure, Essigsäure, Abietinsäure, Buttersäure, Äpfelsäure, Bernsteinsäure, Benzoesäure, Oxalsäure, Maleinsäure, Ölsäure, einem Leichtbenzin, Ethylencarbonat, Ethylenglycolmonobutylether, Dimethylcarbonat, Propylenglycolmethyletheracetat, Propyleneglycolmethyletheracetate, n-Heptan, n-Hexan, Ethen, Propen, Propin, Cyclohexen, Benzol, Chloroform, Vinylchlorid, Acrylsäure, y - Butyrolacton, N-methyl-2-pyrrolidon, Acetonitril, Nitromethan, Triethylamin, Dimethylformamid, Dimethylsulfoxid, Sulfolan, Polyethylen, Polyporpylen, Polystyrol, Polyvinylchlorid, Polysilazan, Rosmarinöl, Lavendelöl und Terpineol oder einer Mischung von mindestens zwei davon. Bevorzugt beinhaltet die Druckmasse ein Terpineol. Bei dem Terpineol kann es sich um jede Mischung eines α-, β- oder γ-Terpineol handeln. Die Druckmasse b), die Druckmasse c) oder die Druckmasse d) kann das organische Additiv jeweils in einem Bereich von 0,1 bis 70 Gew.-%, bevorzugt in einem Bereich von 0,5 bis 50 Gew.-% oder bevorzugt in einem Bereich von 1 bis 30 Gew.-% bezogen jeweils auf das Gesamtgewicht der jeweiligen Druckmasse beinhalten.

Das organische Additiv ist bevorzugt ausgewählt aus der Gruppe bestehend aus einer natürlichen Polymerverbindung und einer synthetischen Polymerverbindung oder eine Mischung hieraus. Die natürliche Polymerverbindung ist bevorzugt ausgewählt aus der Gruppe bestehend aus einem Polysaccharid, einem natürlichen Harz, insbesondere einer Harzsäure, und einem natürlichen Kautschuk, oder einer Mischung von mindestens zwei hieraus. Weiterhin bevorzugt ist das natürliche Polymer ausgewählt aus der Gruppe bestehend aus Cellulose, Chitin, Kolophonium, Terpen cis-1,4-Polyisopren und Terpen trans-1,4-Polyisopren oder einer Mischung aus mindestens zwei hieraus. Die synthetische Polymerverbindung kann linear, verzweigt, cyclisch, polycyclisch, vernetzt und/oder unvernetzt sein und ist bevorzugt ausgewählt aus der Gruppe bestehend aus einem Silikon, einem Kunststoff, einem synthetischen Harz und einem synthetischen Kautschuk. Die synthetische Polymerverbindung ist bevorzugt ausgewählt aus der Gruppe bestehend aus linearen Polysiloxan, wie Dimethylpolysiloxan; einem verzweigten Polysiloxan, einem zyklischen Polysiloxan, einem vernetzten Polysiloxan, einem Polyacrylat, einem Polyethylen, einem Polypropylen, einem Polyketon, einem hydrierten Kohlenwasserstoff-Harz, beispielsweise einem hydrierten Polybutadien-, Polyisopren-, oder Styrol-Butadien-Styrol Harz, einem Phenol-Formaldehyd-Harz, einem Methyl-Kautschuk, Butadien-Acryl-Kautschuk, Chloropren-Kautschuk, Silikonkautschuk und einem Styrol-Butadien-Kautschuk oder einer Mischung aus mindestens zwei hiervon.

Das anorganische Additiv beinhaltet bevorzugt eine anorganische Verbindung. Die anorganische Verbindung ist bevorzugt ausgewählt aus der Gruppe bestehend aus einem Salz, einer metallorganischen Verbindung, einer Keramik, einer Säure, einer Lauge oder einer Mischung von mindestens zwei hiervon. Die anorganische Verbindung ist weiterhin bevorzugt ausgewählt aus der Gruppe bestehend aus einem Metallsalz, einem organischen Salz, einem Ammoniumsalz, einer metallorganischen Verbindung, wie sie zuvor beschrieben wurde, einem Silikat, eine Mineralsäure, einer Karbonsäure, eine wässrige Lauge, eine nichtwässrige Lauge oder einer Mischung von mindestens zwei hiervon. Die anorganische Verbindung ist bevorzugt ausgewählt aus der Gruppe bestehend aus Kalium-, Natrium- oder Magnesiumsulfat, Kalium-, Natrium oder Magnesiumphosphat, Kalium-, Natrium oder Magnesiumsulfat, Kalium-, Natrium- oder Magnesiumphosphat, Aluminiumoxid, Aluminiumchlorid, Aluminiumsulfat, Natriumcitrat, Kaliumcitrat, Ammoniumchlorid, Ammoniumphosphat, Ammoniumsulfat, Ammoniumnitrat, einem Feldspat, einem Glimmer, einem Tonmineral, einem Granat, Salzsäure, Kohlensäure, einer Nukleinsäure, Schwefelsäure, Salpetersäure, salpetrige Säure, Natronlauge, Kalilauge, Ammoniak und einer Nukleinbase oder eine Mischung aus mindestens zwei hiervon.

Weiterhin kann die Druckmasse als anorganisches Additiv eine zusätzliche Metallkomponente in Form mindestens eines Metalls aufweisen. Bevorzugt ist das Metall ausgewählt aus der Gruppe bestehend aus einem Übergangsmetall und einem nicht-Übergangsmetall oder einer Mischung hieraus. Bevorzugt ist das Metall der zusätzlichen Metallkomponente ausgewählt aus der Gruppe bestehend aus Aluminium Zink, Silber, Gold, Kupfer, Platin, Palladium, Nickel, Iridium, Rhodium, Kobalt, Osmium, Ruthenium, Eisen, Mangan, Rhenium, Molybdän, Chrom, Wolfram, Vanadium, Niob, Titan, Zirkonium und Hafnium oder einer Mischung von mindestens zwei davon. Die zusätzliche Metallkomponente entspricht dabei bevorzugt keinem der Metalle, das für die zuvor beschriebene metallorganische Verbindung ausgewählt wurde. Die Druckmasse b), die Druckmasse c) oder die Druckmasse d) können die zusätzliche Metallkomponente jeweils in einem Bereich von 0,001 bis 20 Gew.-%, bevorzugt in einem Bereich von 0,01 bis 15 Gew.-% oder bevorzugt in einem Bereich von 0,05 bis 10 Gew.-% bezogen jeweils auf die jeweilige Druckmasse, beinhalten.

Die erste Metallschicht, die weitere Metallschicht, die zusätzliche Metallschicht oder die äußere Schicht kann das anorganische Additiv jeweils in einem Bereich von 0,001 bis 30 Gew.-%, bevorzugt in einem Bereich von 0,01 bis 20 Gew.-% oder bevorzugt in einem Bereich von 0,05 bis 15 Gew.-% bezogen jeweils auf die jeweilige Druckmasse.

Die Summe der zuvor aufgeführten Bestandteile, die die erste Druckmasse beinhaltet, addieren sich zu 100 Gew.-%. Die Summe der zuvor aufgeführten Bestandteile, die die weitere Druckmasse beinhaltet, addieren sich zu 100 Gew.-%. Die Summe der zuvor aufgeführten Bestandteile, die die zusätzliche Druckmasse beinhaltet, addieren sich zu 100 Gew.-%. Die Summe der zuvor aufgeführten Bestandteile, die die äußere Druckmasse beinhaltet, addieren sich zu 100 Gew.-%.

In einer weiteren bevorzugten Ausgestaltung des Verfahrens ist das Metall der VIII. Nebengruppe ausgewählt aus der Gruppe bestehend aus Nickel, Palladium und Platin oder einer Mischung aus mindestens zwei davon.

Weiterhin ist es bevorzugt, dass sich in dem Verfahren nach dem mindestens teilweisen Überlagern der ersten Metallschicht oder der weiteren Metallschicht oder der zusätzlichen Metallschicht oder der äußeren Schicht jeweils ein Härtungsschritt anschließt. Bevorzugt schließt sich nach allen Schritten b) bis d) jeweils ein Härtungsschritt an. Der Härtungsschritt ist bevorzugt ein Schritt bei dem die Druckmasse ausgehärtet wird. Bei dem Härtungsschritt findet bevorzugt mindestens eine Umwandlung der metallorganischen Verbindung zu einem Metall aus der metallischen Komponente und einer organischen Verbindung aus der organischen Komponente statt. Bevorzugt wird der Härtungsschritt bei einer erhöhten Temperatur, insbesondere in einem Bereich von 100 bis 1100 °C, bevorzugt in einem Bereich von 300 bis 1000 °C, oder bevorzugt in einem Bereich von 500 bis 900 °C ausgeführt. Der Härtungsschritt wird bevorzugt in den angegebenen Temperaturbereichen über einen Zeitraum in einem Bereich von 1 min bis 10 h, bevorzugt in einem Bereich von 5 min bis 5 h, oder bevorzugt in einem Bereich von 10 min bis 3 h durchgeführt. Die Temperatur wird beim Härtungsschritt kontinuierlich oder stufenweise ausgehend von der Umgebungstemperatur auf die Höchsttemperatur erhöht. Das Verfahren ist bevorzugt, wobei mindestens ein Härtungsschritt teilweise in einer Gasatmosphäre mit einem Sauerstoffgehalt von weniger als 20 Vol.-% durchgeführt wird. Es ist bevorzugt, dass mindestens ein, vorzugsweise jeder Härtungsschritt unter Luft oder teilweise in einer Gasatmosphäre mit einem Sauerstoffgehalt von weniger als 20 Vol.-% durchgeführt wird. Die Reduktion des Sauerstoffgehaltes in der Gasatmosphäre kann durch Zuführen von Inertgas ausgewählt aus der Gruppe bestehend aus Stickstoff, Helium, Neon, Argon, Krypton und Xenon oder einer Mischung aus mindestens zwei hiervon, erreicht werden. Das Inertgas ist bevorzugt Stickstoff oder Argon oder eine beliebige Mischung der beiden. Der Härtungsschritt wird dabei so durchgeführt, dass bei niedrigen Temperaturen, bevorzugt in einem Bereich von 25 bis 400 °C, oder bevorzugt in einem Bereich von 25 bis 350 °C, oder bevorzugt in einem Bereiche von 25 bis 150 °C unter Luft mit einem Sauerstoffanteil ca. 20 bis 26 Gew.-% oder 18-23 Volumen-%) gehärtet wird. Bei höheren Temperatur, bevorzugt oberhalb einer Temperatur von 150 °, oder bevorzugt oberhalb einer Temperatur von 350 °, oder bevorzugt oberhalb einer Temperatur von 400 °C wird bevorzugt in einer Atmosphäre mit reduziertem Sauerstoffgehalt von weniger als ca. 20 Vol.-% , bevorzugt weniger als 10 Vol. % gehärtet.

Weiterhin bevorzugt ist das Verfahren, wobei während des Härtungsschritts, welcher teilweise in einer Gasatmosphäre mit einem Sauerstoffgehalt von weniger als 20 Vol.-%, vorzugsweise weniger als 10 Vol.-% und besonders bevorzugt weniger als 5 Vol.-%, jeweils bezogen auf die Gasatmosphäre, durchgeführt wird, die Temperatur, bei der der Wechsel der Atmosphäre zu einem Sauerstoffgehalt von weniger als 20 Vol.-% stattfindet, in einem Bereich von 150 bis 400°C liegt.

Bei dem Härtungsschritt mit erhöhter Temperatur kann die Temperatur durch ein Heizmittel ausgewählt aus der Gruppe bestehend aus einem Ofen, einem Strahler und einem erwärmten Fluid oder einer Mischung aus mindestens zwei hieraus übertragen werden. Bei dem Ofen kann es sich um einen Heißluftofen handeln, der unter Luft oder einer Schutzatmosphäre betrieben werden kann. Der Strahler kann beispielsweise ein UV- oder ein Infrarotstrahler sein. Das erwärmte Fluid kann beispielsweise Luft oder ein Schutzgas oder eine bevorzugt inerte Flüssigkeit sein, die mit der überlagerten Schicht in Kontakt gebracht wird.

In einer bevorzugten Ausgestaltung des Verfahrens weist die erste Metallschicht nach dem Härtungsschritt eine Dicke in einem Bereich von 1 bis 500 µm, bevorzugt in einem Bereich von 2 bis 300 µm, oder bevorzugt in einem Bereich von 4 bis 200 µm aufweist.

Weiterhin ist das Verfahren bevorzugt, wobei die weitere Metallschicht oder die zusätzliche Metallschicht oder beide nach dem Härtungsschritt jeweils eine Dicke in einem Bereich von 0,01 bis 20 µm, oder bevorzugt in einem Bereich von 0,02 bis 10 µm, oder bevorzugt in einem Bereich von 0,03 bis 5,0 µm aufweist.

Das Verfahren ist bevorzugt, wobei die äußere Schicht nach dem Härtungsschritt eine Dicke in einem Bereich von 0,01 bis 1 µm, bevorzugt in einem Bereich von 0,03 bis 0,5 µm aufweist. Die äußere Schicht, vorzugsweise die Gold-Schicht, ist bevorzugt die äußerste Schicht des Schichtaufbaus.

Wie bereits erwähnt, wird bei dem Härtungsschritt bevorzugt die metallorganische Verbindung in ein Metall umgewandelt. Dabei wird bevorzugt die elektrische Leitfähigkeit der jeweiligen Schicht erhöht. Das Verfahren ist bevorzugt, wobei die erste Metallschicht nach dem Härtungsschritt einen auf eine Schichtdicke von 12 µm normierten Flächenwiderstand in einem Bereich von 0,1 bis 10 mOhm/sq aufweist. Der Flächenwiderstand kann sich je nach Material der Schicht bei Erhöhung der Schichtdicke erhöhen oder erniedrigen. Bei elektrischen Leitern, wie Metallen, ist in der Regel zu erwarten, dass der Flächenwiderstand sich erniedrigt, wenn die Schichtdicke der Metallschicht erhöht wird.

Da der Schicht-Aufbau mehrere Metallschichten aufweist, weist der Schicht-Aufbau insgesamt eine gegenüber der keramischen Schicht erhöhte elektrische Leitfähigkeit auf. Das Verfahren ist bevorzugt, wobei der Schicht-Aufbau nach dem Härtungsschritt einen auf eine Schichtdicke von 12 µm normierten Flächenwiderstand in einem Bereich von 0,1 bis 10 mOhm/sq aufweist. Der Schicht-Aufbau weist bevorzugt eine goldene bzw. gelbe Färbung auf.

Weiterhin ist das Verfahren bevorzugt, wobei die äußere Schicht mit einem elektrischen Leiter, beispielsweise in Form eines Drahtes oder Bandes, verbunden wird. Der elektrische Leiter kann auch aus einer Kombination, vorzugsweise einem Schichtaufbau, aus zwei und mehr Metallen bestehen. Der elektrische Leiter kann dazu dienen den Schicht-Aufbau mit weiteren Komponenten einer Leiterplatte oder eines elektrischen oder elektronischen Bauteils, wie Kondensator, Widerstand, elektrische Schalter zu verbinden. Der elektrische Leiter kann aus jedem Material gefertigt sein, der es ermöglicht, elektrischen Strom zu leiten. Der elektrische Leiter kann ausgewählt sein aus der Gruppe bestehend aus einem Metall, einem Halbleitermaterial und einem leitenden Polymer oder einer Mischung aus mindestens zwei hiervon.

In einer bevorzugten Ausgestaltung des Verfahrens beinhaltet der elektrische Leiter ein Metall, ausgewählt aus der Gruppe bestehend aus Kupfer, Aluminium, Eisen, Gold, Platin, Palladium und Silber oder mindestens zwei davon.

Ein weiterer Aspekt der Erfindung betrifft einen Schichtaufbau beinhaltend folgende Schichtabfolge:
■ eine Keramikschicht;
■ mindestens eine Metallschichtengruppe mit einer Schichtabfolge:
   ● eine erste Metallschicht;
   ● eine weitere Metallschicht;
   ● gegebenenfalls eine zusätzliche Metallschicht;
   ● eine äußere-Schicht,

Die äußere Schicht weist nach der Härtung bevorzugt entweder eine glatte, strukturlose Oberfläche oder eine wabenförmige Struktur mit Domänendurchmessern von weniger als etwa 3 µm, bevorzugt von weniger als 2 µm, oder bevorzugt von weniger als 1 µm auf. Der Domänendurchmesser wird dabei an der Stelle bestimmt, an dem die Wabe ihren größten Durchmesser aufweist. Der Domänendurchmesser liegt bevorzugt in einem Bereich von 0,01 bis 3 µm, oder bevorzugt in einem Bereich von 0,05 bis 2 µm, oder bevorzugt in einem Bereich von 0,1 bis 1 µm. Die wabenförmige Struktur weist bevorzugt Waben mit mindestens 3 Ecken auf. Die Wabe weist bevorzugt eine Anzahl von Ecken in einem Bereich von 4 bis 10, bevorzugt in einem Bereich von 5 bis 9, oder bevorzugt in einem Bereich von 6 bis 8 Ecken auf. Die Kantenlängen zwischen den Ecken können gleichförmig oder unterschiedliche sein. Bevorzugt sind die Kantenlängen unterschiedlich lang, sodass eine unsymmetrische Wabenstruktur entsteht. Die Ecken können auch abgerundet sein.

In einer bevorzugten Ausgestaltung des Schichtaufbaus beinhaltet die erste Metallschicht ein Metall, ausgewählt aus der Gruppe bestehend aus Silber und Kupfer oder einer Mischung daraus.

Bevorzugt ist der Schichtaufbau, wobei der Schichtaufbau mindestens eine, vorzugsweise alle, der folgenden Eigenschaften aufweist:
e1. die Dicke der ersten Metallschicht liegt in einem Bereich von 1 bis 500 µm, die Dicke der weiteren Metallschicht liegt in einem Bereich von 0,05 bis 20 µm, die Dicke der zusätzlichen Metallschicht liegt in einem Bereich von 0,05 bis 10 µm und die Dicke der äußeren Schicht liegt in einem Bereich von 0,01 bis 1 µm;
e2. die Dicke der Schichten nimmt bevorzugt von der ersten Metallschicht über die weitere Metallschicht, gefolgt von der zusätzliche Metallschicht zur äußeren Schicht hin ab;
e3. der Kontaktwinkel der Oberfläche der äußeren Schicht gegenüber reinem Wasser liegt in einem Bereich von 70 bis 100°;

Weiterhin bevorzugt ist der Schichtaufbau, wobei der Schichtaufbau mindestens eine, vorzugsweise alle, der folgenden Eigenschaften aufweist:
e4. das Verhältnis der Schichtdicken der ersten Metallschicht zur weiteren Metallschicht in einem Bereich von 1:1 bis 1:150 liegt, bevorzugt in einem Bereich von 1:1 bis 1:100, oder bevorzugt in einem Bereich von 1:1 bis 1:50;
e5. das Verhältnis der Schichtdicken der zusätzlichen Metallschicht zur weiteren Metallschicht in einem Bereich von 10:1 bis 1:1 liegt, bevorzugt in einem Bereich von 5:1 bis 1:1, oder bevorzugt in einem Bereich von 3:1 bis 1:1;
e6. das Verhältnis der Schichtdicken der äußeren Schicht zur weiteren Metallschicht in einem Bereich von 3:1 bis 10:1 1 liegt, bevorzugt in einem Bereich von 2:1 bis 7:1, oder bevorzugt in einem Bereich von 1:1 1 bis 5:1.

Bevorzugt weist der Schichtaufbau mindestens eine Kombination der Eigenschaften e4, e5 und e6 auf. Bevorzugt ist die Kombination der Eigenschaften ausgewählt aus der Gruppe bestehend aus e4 mit e5, e4 mit e6, e5 mit e6 und e4 mit e5 und e6.

Ein weiterer Aspekt der Erfindung betrifft einen erster Schichtaufbauvorläufer erhältlich mindestens in Teilen oder ganz nach dem zuvor beschriebenen Verfahren, wobei der erste Schichtaufbauvorläufer die Keramikschicht und die erste Metallschicht mit einer Dicke in einem Bereich von 1 bis 50 µm beinhaltet sowie die weitere Metallschicht in Form einer flüssigen Druckmasse, wobei der erste Schichtaufbauvorläufer mindestens eine der folgenden Eigenschaften aufweist:
ES1 die Dicke der Druckmasse der weiteren Metallschicht liegt in einem Bereich von 4 bis 25 µm Nassschichtdicke;
EP2 die Viskosität der Druckmasse für die weitere Metallschicht liegt in einem Bereich von 500 bis 50000 mPas.

Die Zusammensetzungen, Eigenschaften und Parameter der Keramikschicht sowie der ersten, der weiteren entsprechen den Angaben zu dem zuvor beschriebenen Verfahren.

Weiterhin betrifft ein Aspekt der Erfindung einen zweiten Schichtaufbauvorläufer erhältlich mindestens in Teilen nach dem zuvor beschriebenen Verfahren, wobei der zweite Schichtaufbauvorläufer die Keramikschicht und die erste Metallschicht mit einer Dicke in einem Bereich von 1 bis 50 µm beinhaltet sowie die gehärtete weitere Metallschicht mit einer Dicke in einem Bereich von 0,01 bis 20 µm und die zusätzliche Metallschicht in Form einer flüssigen Druckmasse, wobei der zweite Schichtaufbauvorläufer mindestens eine der folgenden Eigenschaften aufweist:
EP3 die Dicke der Druckmasse für die zusätzliche Metallschicht liegt in einem Bereich von 4 bis 25 µm Nassschichtdicke;
EP4 die Viskosität der Druckmasse für die zusätzliche Metallschicht liegt in einem Bereich von 500 bis 50000 mPas.

Die Zusammensetzungen, Eigenschaften und Parameter der Keramikschicht sowie der ersten, der weiteren und der zusätzlichen Metallschicht entsprechen den Angaben zu dem zuvor beschriebenen Verfahren.

Ein weiterer Aspekt der Erfindung betrifft einen dritter Schichtaufbauvorläufer erhältlich mindestens in Teilen nach dem zuvor beschriebenen Verfahren, wobei der dritte Schichtaufbauvorläufer die Keramikschicht, die erste Metallschicht mit einer Dicke in einem Bereich von 1 bis 50 µm, die gehärtete weitere Metallschicht mit einer Dicke in einem Bereich von 0,01 bis 20 µm und die gehärtete zusätzliche Metallschicht mit einer Dicke in einem Bereich von 0,05 bis 10 µm beinhaltet sowie die äußeren Schicht in Form einer flüssigen Druckmasse, wobei der dritte Schichtaufbauvorläufer mindestens eine der folgenden Eigenschaften aufweist:
EP5 die Dicke der Druckmasse für die äußere Schicht liegt in einem Bereich von 4 bis 30 µm Nassschichtdicke;
EP6 die Viskosität der Druckmasse für die äußere Schicht liegt in einem Bereich von 500 bis 50000 mPas.

Ein weiterer Aspekt der Erfindung betrifft einen Schichtaufbau erhältlich nach dem zuvor beschriebenen Verfahren, wobei der Schichtaufbau mindestens eine der folgenden Eigenschaften aufweist:
ES 1 einen Kontaktwinkel der Oberfläche der äußeren Schicht gegenüber reinem Wasser liegt in einem Bereiche von 70 bis 100°;
ES2 die Dicke der ersten Metallschicht liegt in einem Bereich von 1 bis 50 µm, die Dicke der weiteren Metallschicht liegt in einem Bereich von 0,01 bis 20 µm, die Dicke der zusätzlichen Metallschicht liegt in einem Bereich von 0,05 bis 10 µm und die Dicke der äußeren Schicht liegt in einem Bereich von 0,01 bis 1 µm;
ES3 die Dicke der Schichten nimmt von der ersten Metallschicht über die weitere Metallschicht, gefolgt von der zusätzlichen Metallschicht zur äußeren Schicht hin ab.

Ein weiterer Aspekt der Erfindung betrifft ein elektrisches Bauteil beinhaltend einen integrierten Schaltkreis und einen zuvor beschriebenen Schichtaufbau.

Das elektrische Bauteil ist bevorzugt, wobei der integrierte Schaltkreis über einen ersten elektrischen Leiter mit dem Schichtaufbau verbunden ist und der Schichtaufbau über einen zweiten elektrischen Leitermit einem elektrischen Kontakt, beispielsweise einer Steckerleiste, einem weiteren integrierten Schaltkreis, einem Widerstand, einem Kondensator, einer Diode, einem Schalter oder einem Display, verbunden ist. Bei dem elektrischen Kontakt kann es sich um jedes elektrische Bauelement handeln, das der Fachmann im Zusammenhang mit elektrischen Bauteilen kennt. Bevorzugt ist das elektrische Bauteil ausgewählt aus einer Gruppe bestehend aus integrierter Schaltkreis, Widerstand, Kondensator, Diode, Schalter und Display.

Weiterhin ist das elektrische Bauteil bevorzugt, wobei der erste elektrische Leiter ein edleres Metall beinhaltet als der zweite elektrische Leiter. Unter dem Ausdruck edleres Metall ist ein Metall zu verstehen, das gegenüber einer Wasserstoffelektrode in wässriger Lösung bei pH 7 ein höheres Normalpotenzial besitzt als das andere Metall, das folglich unedler ist. Der erste oder der zweite elektrische Leiterbeinhalten ein Metall ausgewählt aus der Gruppe bestehend aus Silber, Aluminium, Kupfer, einer Kupferlegierung, Eisen, Nickel, und Zink oder eine Mischung aus mindestens zwei hieraus. Der erste elektrische Leiter ist bevorzugt kürzer als der zweite elektrische Leiter. Bevorzugt sind die Längen des ersten und des zweiten elektrischen Leiters in einem Bereich von 0,5 mm bis 10 cm, oder bevorzugt in einem Bereich von 1 mm bis 5 cm, oder bevorzugt in einem Bereich von 3 mm bis 1 cm. Der Durchmesser des ersten oder des zweiten elektrischen Leiters beträgt 10 µm bis 500 µm.

Ein weiterer Aspekt der Erfindung betrifft ein Fahrzeug beinhaltend ein elektrisches Bauteil nach einem der Ansprüche 21 bis 23.

Weiterhin betrifft ein Aspekt der Erfindung ein Kit beinhaltend
i. eine erste Paste, beinhaltend mindestens zu einem Teil eine erste metallorganische Verbindung, beinhaltend mindestens ein Metall der VIII. Nebengruppe;
ii. eine zweite Paste, beinhaltend mindestens zu einem Teil eine zweite metallorganische Verbindung, beinhaltend mindestens ein Metall der VIII. Nebengruppe;
iii. eine dritte Paste, beinhaltend mindestens zu einem Teil eine metallorganische Verbindung, beinhaltend mindestens ein Metall ausgewählt aus der Gruppe
bestehend aus Palladium, Platin, Ruthenium, Rhodium, Silber und Gold; wobei in mindestens einer, vorzugsweise jeder, der vorstehenden Pasten das oder die Metalle als metallorganische Verbindung vorliegen.

Zudem gelten die Ausführungen zu dem Verfahren zur Herstellung des Schichtaufbaus ebenso entsprechend für den erfindungsgemäßen Schichtaufbau, die erfindungsgemäßen Vorläufer für einen Schichtaufbau und die erfindungsgemäßen elektrischen Bauteile und Fahrzeuge sowie für das erfindungsgemäße Kit. Dies gilt insbesondere für Materialien und räumliche Ausgestaltungen.

### Beispiele

### Keramikschicht mit erster Metallschicht:

In allen folgenden Beispielen wurden als Keramikschicht quadratische Aluminiumoxid Platten (Rubalit 708 S von CeramTec) mit einer Dicke von 0,625 mm und einer Kantenlänge von 2 Zoll verwendet, auf die eine Silberschicht als erste Schicht aufgebracht wurde. Zur Herstellung der ersten Metallschicht wurden zwei unterschiedliche Silberpasten verwendet, die im Folgenden beschrieben sind und wobei der Härtungsschritt unter Luft durchgeführt wurde.

Silberschicht I: Die Silberschicht I wurde aus einer Silberleitpaste (C8717 B von Heraeus) hergestellt, die via Siebdruck, wie später noch beschrieben wird, auf die Keramikplatten in einer Nassfilmdicke von 20-25 µm aufgedruckt und bei 150°C für 20 Minuten getrocknet wurde. Der Härtungsschritt erfolgte durch Erhitzen von Raumtemperatur auf 850°C innerhalb von 25 Minuten. Die Temperatur von 850 °C wurde für 12 Minuten gehalten und anschließend innerhalb von 25 Minuten auf Rauntemperatur abgekühlt. Die gebildete Silberschicht in Form eines Silberfilms hatte eine Dicke von ca. 10-15 µm und einen auf eine Schichtdicke von 50 µm genormten Flächenwiderstand von <2,5 mΩ/sq.

Silberschicht II: Die Silberschicht II wurde aus einer Silberleitpaste (C8729H von Heraeus) hergestellt, die via Siebdruck, wie später noch beschrieben wird, auf die Keramikplatten in einer Nassfilmdicke von ca. 20-25 µm aufgedruckt und bei 150°C 20 Minuten getrocknet. Der Härtungsschritt erfolgte durch Erhitzen von Raumtemperatur auf 850°C innerhalb von 25 Minuten. Die Temperatur von 850 °C wurde für 12 Minuten gehalten und anschließend innerhalb von 25 Minuten auf Rauntemperatur abgekühlt. Die gebildete Silberschicht II in Form eines Silberfilms hatte eine Dicke von ca. 10-15 µm und einen auf eine Schichtdicke von 12 µm genormten Flächenwiderstand von < 1 mΩ/sq.

### Organisches Additiv (genannt organisches Vehikel V)

Das verwendete organische Vehikel V wurde hergestellt aus 15 Gewichts-Teilen Ethylcellulose Aqualon Typ N (von Ashland) und 85 Gewichts-Teilen Texanol (von Aldrich). Die Viskosität wurde mit Hilfeeines Platte-Kegel System Haake RS 600 mit Software Version 4.00.0007 (von Fisher Scientific) bei einer Temperatur von 25 °C unter Verwendung eines C20/0,5° Ti Messkegels gemessen. Dabei wurde die Scherrate in 6 Minuten von 0,1 s⁻¹ auf 150 s⁻¹ erhöht, für 1 Minute auf 150 s⁻¹ gehalten und dann innerhalb von 6 Minuten auf 0,1 s⁻¹ abgesenkt. Die Viskosität wurde bei einer Scherrate von 100 s⁻¹ bei absinkender Scherrate ermittelt und betrug 10 - 30 Pa*s.

### Druckmassenherstellung

Zur Herstellung der Druckmassen a) bis d) wurden die jeweiligen Komponenten in ein Becherglas eingewogen und mit einem Glasstab per Hand vorhomogenisiert. Diese Masse wurde mit einem Dreiwalzenstuhl Exakt E80 mit Keramikwalzen aus Aluminiumoxid (von EXAKT Advanced Technologies GmbH) und 45 µm für den 1. Walzenabstand und 15 µm für den 2. Walzenabstand, einer Geschwindigkeit von 50 UPM für die 1. Walze und 150 UPM für die 3. Walze homogenisiert. Dabei wurden die Massen mindestens 4-mal über den Walzenstuhl geleitet bzw. geschickt.

### Viskositätsmessung

Die Viskosität der Druckmassen wurde mit einem Platte-Kegel System Physica MCR 301 mit Software Rheoplus Version 32 V3.40 (von Anton Paar) bei einer Temperatur von 20 ± 0,1 °C unter Verwendung eines CP 25-1 Messkegels (Winkel 1°) gemessen. Nach 30 Sekunden Temperierung wurde eine Rampe der Scherrate von 1s⁻¹ bis 500 s⁻¹ mit 25 äquidistanten Schritten, wobei jeder Schritt für eine Dauer von jeweils 30 Sekunden gleich gehalten wurde, erzeugt. Die Scherrate von 500 s⁻¹ wurde für 30 Sekunden gehalten. Anschließend wurde die Scherrate in 25 äquidistanten Schritten, wie oben auf 1 s⁻¹ reduziert. Die Viskosität wurde bei einer Scherrate von 500 s⁻¹ am Ender der 30 Sekunden bestimmt.

### Siebdruck

Alle Schichten des in den Beispielen beschriebenen Schichtaufbaus wurden mittels Siebdruck aufgebracht. Bei den dabei verwendeten Sieben von der Firma DEK handelte es sich um Siebe aus Edelstahl mit 325 mesh, mit einem Drahtdurchmesser von 30 µm, einer Maschenweite von 50 µm, einem Sieböffnungsgrad von 45°. Es wurde mit einer 20 µm dicken Emulsion beschichtet. Der Druck erfolgte in einer DEK 248 (von DEK International) mit einer Streifenrakel mit einer Härte von 75 Shore A, einer Rakelgeschwindigkeit von 7 cm/s einem Rakelwinkel von 60° und einem Absprung von 0,6 mm.

### Trocknung

20 Minuten nach dem Drucken der Pasten wurden die Proben in einem Trockenschrank Function Line (von Kendro) bei einer Temperatur von 70°C während 30 Minuten im Fall der weiteren und zusätzlichen Metallschicht und von 90°C während 15 Minuten im Fall der äußeren Metallschicht für 20 Minuten getrocknet.

### Härtungsschritt

Profil 1: Die weitere Metallschicht wurde gehärtet, indem die Proben in einem Ofen PEO 603 (von ATV Technologie GmbH) verwahrt wurde, dessen Temperatur innerhalb von 25 Minuten von 28°C auf 230°C erhöht wurde, die Temperatur für 10 Minuten bei 230 °C gehalten wurde, anschließend innerhalb von 20 Minuten auf 800°C und anschließend innerhalb von 40 Minuten auf ca. 50°C reduziert wurde. Das Aufheizen bis 230 °C erfolgte unter einem Luftstrom von 600 1/h. Während der Haltezeit bei 230°C wurde der Luftstrom durch einen Stickstoffstrom (N₂ 5.0 ) von 600 1/h ersetzt und bis zum Ende der Abkühlphase beibehalten. Nachfolgend wird dieser Härtungsschritt als Profil 1 bezeichnet.

Profil 2: Die zusätzliche Metallschicht wurde gehärtet, indem die Proben in einem Ofen PEO 603 (von ATV Technologie GmbH) verwahrt wurde, dessen Temperatur innerhalb von 25 Minuten von 28°C auf 230°C erhöht wurde, anschließend die Temperatur für 10 Minuten bei 230°C gehalten wurde, anschließend innerhalb von 20 Minuten auf 800°C und anschließend in 40 Minuten auf ca. 50°C reduziert wurde. Das Aufheizen auf eine Temperatur von 230°C erfolgte unter einem Luftstrom von 600 1/h. Während der Haltezeit bei 230°C wurde der Luftstrom durch einen Stickstoffstrom (N₂ 5.0) von 600 1/h ersetzt und bis zum Ende der Abkühlphase beibehalten. Nachfolgend wird dieser Härtungsschritt als Profil 2 bezeichnet.

Profil 3: Die äußere Metallschicht wurde gehärtet, indem die Proben in einem Ofen PEO 603 (von ATV Technologie GmbH) verwahrt wurde, dessen Temperatur innerhalb von 25 Minuten von 28°C auf 350°C erhöht wurde, anschließend die Temperatur für 15 Minuten bei 350°C gehalten wurde, anschließend die Temperatur innerhalb von 20 Minuten auf 650°C erhöht und anschließend in 40 Minuten auf ca. 60°C reduziert wurde. Das Aufheizen bis 350°C erfolgte unter einem Luftstrom von 600 1/h. Während der Haltezeit bei 350°C wurde der Luftstrom durch einen Stickstoffstrom (N₂ 5.0) von 600 1/h ersetzt und bis zum Ende der Abkühlphase beibehalten. Nachfolgend wird dieser Härtungsschritt als Profil 3 bezeichnet.

Profil 4: Entspricht dem Profil 3, wobei der Härtungsschritt über den ganzen Temperaturzyklus von Anfang bis Ende unter Luft erfolgt.

### Schichtdickenmessung

Zur Schichtdickenmessung der, wie oben beschrieben, gehärteten Schichten wurde ein Zeiss 5104775 Lichtschnittmikroskop (Zeiss) mit 200-facher Vergrößerung eingesetzt. Zu den Messungen wurde die bedruckte und gehärtete Probe auf den Probentisch gelegt und die 0 Position eingestellt. Anschließend wurde die horizontale Linie des Fadenkreuzes auf die Oberfläche des Substrates ausgerichtet. Danach wird das Fadenkreuz auf die Schichtoberfläche ausgerichtet und der Messwert abgelesen. Die Messungen wurden bei Raumtemperatur durchgeführt.

### Rauhigkeitsmessung

Zur Rauhigkeitsmessung der gehärteten Schichten wurde ein Abtastsystem Hommel-Etamic mit Software Turbo-Wave V7.30 (beide von Jenoptik) eingesetzt. Zu den Messungen wurde der Taster TK 300 (mit einem vertikalen Messbereich von 400 µm) mittels Linearvorschub (Waveline 60) über eine Messstrecke von 5,6 mm mit einer Geschwindigkeit von 0,5mm/sec bewegt. Als Filter wurde der M1 Filter und als Cut off wurden 0,800 mm angewendet. Es wurden jeweils 10 Messungen zur Bestimmung der mittleren Rauigkeit Ra, gemittelt. Die Messungen wurden bei Raumtemperatur durchgeführt.

### Kontaktwinkelmessung

Die Kontaktwinkelmessungen wurden am liegenden Tropfen Wasser mit einen Krüss DAS 10-MK2, unter Verwendung der Software Drop Shape Analysis Version 1.90.0.11 (Krüss), einer Kameravergrößerung von 1,5, einem Tropfenvolumen von ca. 1,5 µl und einem Durchfluss von ca. 6,3 µl/min bei Raumtemperatur (23°C) durchgeführt. Als Kapillare diente eine NE 41 (Krüss) und bei dem verwendeten reinen Wasser handelte es sich um Wasser für die Chromatographie LiChrosolv (1.15333.1000 Merck).

### Flächenwiderstandsmessung

Die Messung des Flächenwiderstandes wird bei einer Temperatur von 23°C mit Hilfe eines Digitalmultimeters HP34410A (Hewlet Packard) durchgeführt. Dazu wurden die Elektroden auf den entgegengesetzten Enden einer Leiterbahn mit einer Länge von 65 mm, einer Breite von 5 mm (=130 squares) und der gemessenen Schichtdicke, die auf dem Substrat entsprechend aufgedruckt wurde, platziert und der angezeigte Widerstandswert abgelesen. Die Messung wurde 5 Mal wiederholt und der Mittelwert der Messwerte geteilt durch die Anzahl squares ergibt den Flächenwiderstand. Der normierte Flächenwiderstand wurde berechnet, indem die gemessene Schichtdicke durch die Normschichtdicke geteilt und mit dem gemessenen Flächenwiderstand multipliziert wurde.

### Haftung

Zur Bestimmung der Haftung wurde Golddraht AU-HD5 (Heraeus) mit einem Durchmesser von 30 µm mittels einer Bondingmaschine ESEC 3088 (ESEC) nach dem Ball-Wedge-Verfahren und Ultraschall auf die gehärteten Oberflächen gebonded. Als Kapillare wurde eine Kulicke & Soffa 41413-0010-R34 (Kulicke & Soffa ) verwendet. Die verwendeten Parameter lauteten:

| Parameter | Ball | Wedge |
|---|---|---|
| Impact force | 180 mN | 600 mN |
| Bond force | 330 mN | 500 mN |
| Time | 26 ms | 20 ms |
| Ultra Sonic (US) | 22% | 22% |
| Pre US | 5% | 8% |
| US profile | short burst medium | short burst medium |
| Wedge delay | | 4 ms |
| US power compensation | | 0,3 |
| Wedge bond force compensation | | 0,2 |

An den gebondeten Golddrähten wurden mit einer Dages Series 4000, ausgerüstet mit einer Kraftmessdose WP100 (beides Dage-Nordson), Zugversuche bei Raumtemperatur (23°C) durchgeführt. Der Haken Dage 400-HK-6-3 (Dage-Nordson) wurde dazu in der Mitte des Bondloops positioniert und mit einer Geschwindigkeit von 500 µm/s senkrecht zur Probenoberfläche von dieser weg bewegt. Die maximal erreichte Bruchkraft wurde bestimmt und diente als Maß für die Haftung. Es wurden jeweils 30 Bondloops vermessen und der Mittelwert gebildet.

### 1. Herstellung geeigneter Nickelhaltiger Pasten als Druckmasse b) zur Herstellung einer erfindungsgemäßen weiteren Schicht

### 1.1. Beispiel 1.1

In einem Becherglas wurden 16,7 g (48,7 mmol) Nickel (II) Ethylhexanoat (von der Firma Sigma Aldrich GmbH) mit 55,0 g des organischen Vehikels V und 28,3 g Terpineol (Isomerengemisch von Aldrich) vermischt und homogenisiert. Die erhaltene Paste hatte eine Viskosität von 6040 mPas und war siebdruckfähig. Nach Druck der Paste auf die Keramikschicht mit erster Metallschicht wurden die Proben getrocknet und gehärtet. Es wurde eine homogene Nickelschicht erhalten. Die genauen Bedingungen und Eigenschaften des Schichtaufbaus sind in Tabelle 1 zusammengefasst.

### 1.2. Beispiel 1.2

In einem Becherglas wurden 8,3 g (24,0 mmol) Nickel (II) Ethylhexanoat (von der Firma Sigma Aldrich GmbH) mit 5,5 g (21,41 mmol) Nickel (II) Acetylacetonat (Sigma Aldrich GmbH), 76,2 g des organischen Vehikels V und 10,0 g Terpineol (Isomerengemisch von Aldrich) vermischt und homogenisiert. Die erhaltene Paste hatte eine Viskosität von 5770 mPas und war siebdruckfähig. Nach Druck der Paste auf die Keramikschicht mit erster Metallschicht wurden die Proben getrocknet und gehärtet. Es wurde eine homogene Nickelschicht erhalten. Die genauen Bedingungen und Eigenschaften des Schichtaufbaus sind in Tabelle 1 zusammengefasst.

**Tabelle 1:**

| Beispiel | Erste Metallschicht | Trocknungsbedingungen | Härtungsbedingungen | Schichtdicke gehärteter Schichtaufbau [µm] | Flächenwiderstand auf 12 µm normiert [mΩ/sq] |
|---|---|---|---|---|---|
| 1.1 | Silberschicht II | 70°C 30 min | Profil 1, | 12 | 1,75 |
| 1.2 | Silberschicht II | 70°C 30 min | Profil 1 | 12 | 1,81 |

### 2. Herstellung geeigneter Goldhaltiger Pasten als Druckmasse d) zur Herstellung einer äußeren-Schicht

### 2.1. Beispiel 2.1

Für dieses Beispiel wurde eine kommerziell erhältliche Goldpaste RP AU 080910 - 22% (Heraeus Precious Metals GmbH & Co. KG) mit einem Goldanteil von 22% bezogen auf die Gesamtmasse der Paste verwendet. Die Paste enthält Gold in Form eines Sulforesinates sowie alpha-Terpineol, Rosmarinöl, Toluol, Kolophonium, und Kopaivabalsam als Lösungsmittel und polymere organische Additive. Die Paste hat eine Viskosität von 20-30 Pa*s (bei 50 s⁻¹) Die Paste wurde mittels Siebdruck auf einen Schichtaufbau nach Beispiel 1.1 gedruckt. Anschließend wurde der Schichtaufbau mit dem entsprechenden Profil gehärtet. Es wurde eine homogene Gold-Schicht als äußere Schicht erhalten. Weitere Daten sind in Tabelle 2 zusammengefasst.

**Tabelle 2:**

| Beispiel | Erste Metallschicht | Weitere Metallschicht | Äußere Metallschicht | Härtungsbedingungen | Schichtdicke gehärteter Schichtaufbau [µm] | Flächenwiderstand auf 12 µm normiert [mΩ/sq] | Rauhigkeit Ra [µm] | Kontaktwinkel [°] | Haftung [cN] |
|---|---|---|---|---|---|---|---|---|---|
| 2.1a | Silberschicht I | Beispiel 1.1 | Beispiel 2.1 | Profil 1 | | | 0,56 | 98 | 10,1 |
| | | | | Profil 4 | | | | | |
| 2.2a | Silberschicht I | Beispiel 1.2 | Beispiel 2.1 | Profil 1 | 21 | 5,39 | | 80 | |
| | | | | Profil 3 | | | | | |
| 2.1b | Silberschicht II | Beispiel 1.1 | Beispiel 2.1 | Profil 1 | | | 0,46 | 92 | 13,1 |
| | | | | Profil 4 | | | | | |
| 2.2b | Silberschicht II | Beispiel 1.2 | Beispiel 2.1 | Profil 1 | 12 | 2,79 | | 79 | |
| | | | | Profil 3 | | | | | |

### 3. Herstellung geeigneter paladiumhaltiger Pasten als Druckmasse c) zur Herstellung einer zusätzlichen Schicht

### 3.1. Beispiel 3.1

In einem Becherglas wurden 21,4 g Palladiumneodecanoat (Chemos GmbH) mit 70,3 g des organischen Vehikels V und 8,3 g Texanol (Aldrich), wie oben beschrieben, vermischt und homogenisiert. Die erhaltene Paste hatte eine Viskosität von 5000 mPas (bei einer Scherrate von 100 s⁻¹) und war siebdruckfähig. Nach dem Drucken der Paste auf die Keramikschicht mit erster und weiterer Metallschicht wurden die Proben getrocknet und nach Profil 2 gehärtet. Es wurde eine homogene Palladiumschicht erhalten. Dies Proben wurden anschließend mit der Paste aus Beispiel 3.1 bedruckt, getrocknet und nach Profil 3 gehärtet. Die genauen Bedingungen und Eigenschaften des Schichtaufbaus sind in Tabelle 3 zusammengefasst.

**Tabelle 3:**

| Beispiel | Erste Metallschicht | Weitere Metallschicht | Zusätzliche Metallschicht | Äußere Metallschicht | Härtungsbedingungen | Schichtdicke gehärteter Schichtaufbau [µm] | Flächenwiderstand auf 12 µm normiert [mΩ/sq] | Kontaktwinkel | Haftung[cN] |
|---|---|---|---|---|---|---|---|---|---|
| 3.1a | Silberschicht I | Beispiel 1.2 | Beispiel 3.1 | Beispiel 2.1 | Profil 1 | 21 | 4,15 | 79 | |
| | | | | | Profil 2 | | | | |
| | | | | | Profil 3 | | | | |
| 3.1b | Silberschicht II | Beispiel 1.2 | Beispiel 3.1 | Beispiel 2.1 | Profil 1 | 12 | 4,54 | 82 | |
| | | | | | Profil 2 | | | | |
| | | | | | Profil 3 | | | | |
| 3.1c | Silberschicht II | Beispiel 1.1 | Beispiel 3.1 | Beispiel 2.1 | Profil 1 | 12 | 3,28 | 91 | 19,2 |
| | | | | | Profil 2 | | | | |
| | | | | | Profil 4 | | | | |
| 3.1d | Silberschicht II | Beispiel 1.2 | Beispiel 3.1 | Beispiel 2.1 | Profil 1 | 12 | 2,64 | 90 | |
| | | | | | Profil 2 | | | | |
| | | | | | Profil 4 | | | | |

### Rasterelektronenmikroskopie REM

Einige Proben wurden mittels REM untersucht. Dazu wurden Sie im Vakuum (etwa 1*10⁻¹ mbar) in einem Sputter Coater S150b (Edwards), unter Verwendung von Argon, bei einer Spannung von 1,5kV und einem Strom von ca. 40 mA ca. 1 Minute mit Platin besputtert. Die Untersuchung erfolgte in einem Zeis Ultra 55 (von Zeiss) mit Feldemissionskathode, einer Beschleunigungsspannung von 20 kV und bei einem Vakuum von etwa 3*10⁻⁶ mbar.

### Kurze Beschreibung der Figuren

Weitere Einzelheiten und Merkmale der Erfindung ergeben sich aus der nachfolgenden Beschreibung von bevorzugten Ausführungsbeispielen, insbesondere in Verbindung mit den Unteransprüchen. Hierbei können die jeweiligen Merkmale für sich alleine oder zu mehreren in Kombination miteinander verwirklicht sein. Die Erfindung ist nicht auf die Ausführungsbeispiele beschränkt. Die Ausführungsbeispiele sind in den Figuren schematisch dargestellt. Gleiche Bezugsziffern in den einzelnen Figuren bezeichnen dabei gleiche oder funktionsgleiche beziehungsweise hinsichtlich ihrer Funktionen einander entsprechende Elemente.

Im Einzelnen zeigen:
- Figur 1:: Schematische Darstellung eines Schichtaufbaus;
- Figur 2:: Schematische Darstellung eines elektrischen Bauteils mit Anschlussdrähten von Schichtaufbau zu elektrischen Kontakten;
- Figur 3a:: Schematische Darstellung eines ersten Schichtaufbauvorläufers;
- Figur 3b:: Schematische Darstellung eines zweiten Schichtaufbauvorläufers;
- Figur 3c:: Schematische Darstellung eines dritten Schichtaufbauvorläufers;
- Figur 4:: Schematische Darstellung eines Verfahrensablaufs;
- Figur 5:: Schematische Darstellung eines Fahrzeugs mit einem Schichtaufbau;
- Figur 6:: Schematische Darstellung eines Kits;
- Figur 7a:: REM Aufnahme einer Oberfläche eines erfindungsgemäßen Schichtaufbaus hergestellt gemäß Beispiel 2.1 a;

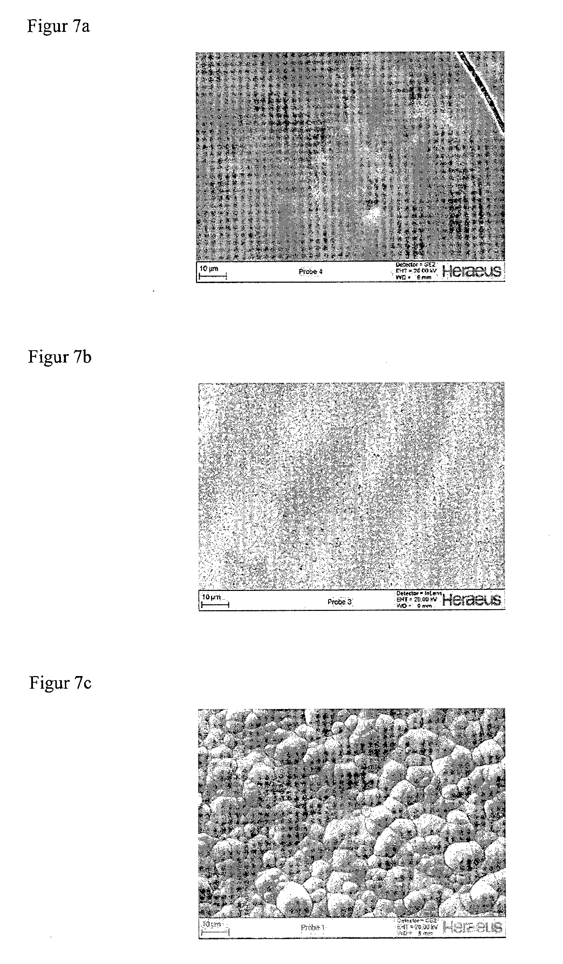

- Figur 7a:: REM Aufnahme einer Oberfläche eines erfindungsgemäßen Schichtaufbaus hergestellt gemäß Beispiel 3.1 a;
- Figur 7c:: REM Aufnahme einer Oberfläche eines Schichtaufbaus aus dem Stand der Technik, hergestellt gemäß der ENIPIG Methode.

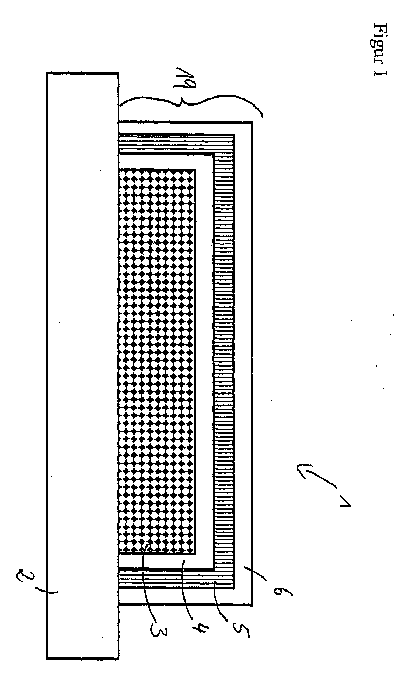

In Figur 1 ist ein erfindungsgemäßer Schichtaufbau 1 schematisch dargestellt. Der Schichtaufbau 1 weist eine Keramikschicht 2, bevorzugt eine Al₂O₃-Keramikschicht 2, auf. Auf diese Keramikschicht 2 folgt eine erste Metallschicht 3, im bevorzugten Fall eine Silberschicht. Die erste Metallschicht 3 ist überlagert mit einer weiteren Metallschicht 4, im bevorzugten Fall bestehend aus einer Nickelschicht. Die weitere Metallschicht ist wiederum mit einer zusätzlichen Metallschicht 5, im bevorzugten Fall einer Palladiumschicht, überlagert. Die äußere Schicht bildet in diesem Schichtaufbau 1 eine Schicht 6, die im bevorzugten Fall aus Gold besteht. Die erste Metallschicht 3 zusammen mit der weiteren Metallschicht 4, der zusätzlichen Metallschicht 5 und der äußeren Schicht 6 bilden eine Metallschichtengruppe 19.

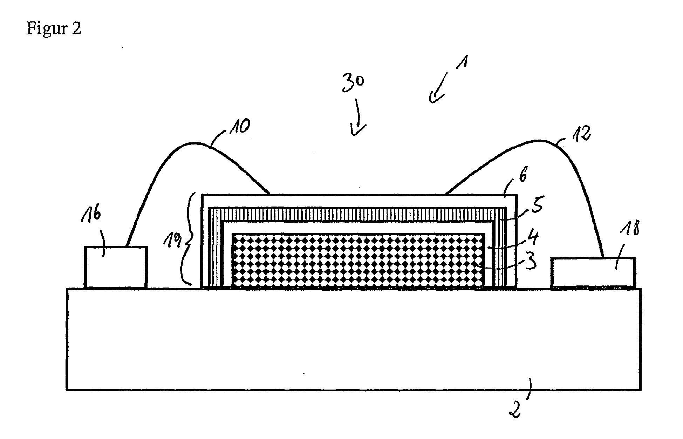

In Figur 2 ist der erfindungsgemäße Schichtaufbau 1 aus Figur 1 im Einsatz in einem elektrischen Bauteil 30 gezeigt. In diesem elektrischen Bauteil 30 wird die äußere Schicht 6 des Schichtaufbaus 1 über einen ersten elektrischen Leiter 12mit einem elektrischen Bauteil 18 verbunden. Weiterhin wird die äußere Schicht über einen zweiten elektrischen Leiter 14 mit einem integrierten Schaltkreis 16 verbunden.

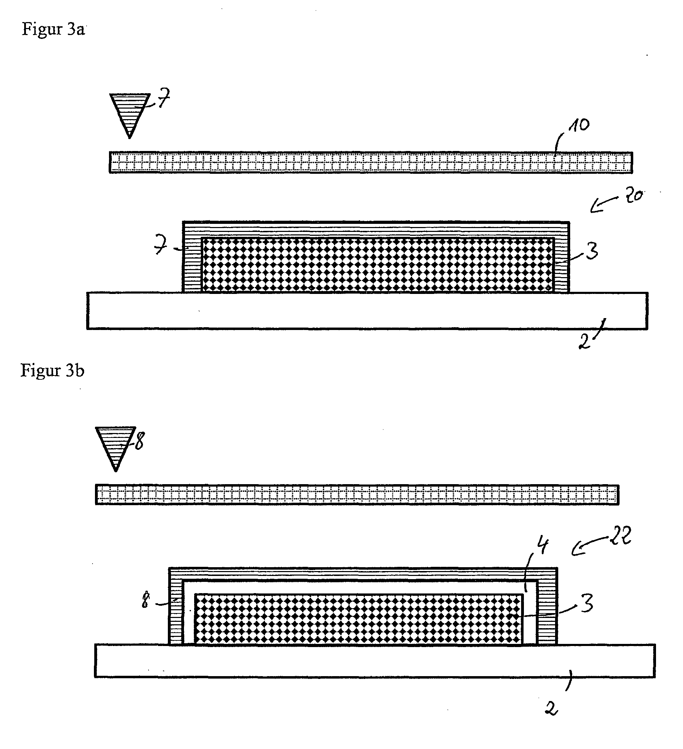

Die Figur 3a zeigt schematisch einen ersten Schichtaufbauvorläufer 20. Hierin ist auf eine Keramikschicht 2, wie bereits für Figur 1 beschrieben, eine erste Metallschicht 3 angeordnet. Hierauf wird mittels eines Siebs 20, die Druckmasse 7 aus Schritt b) aufgebracht. Die erste Metallschicht 3 ist nun vollständig mit einer Druckmasse 7 überlagert. Mit Hilfe einer Rakel (hier nicht gezeigt wird die Druckmasse 7 gleichmäßig durch das Sieb 10 gedrückt. Es bildet sich ein Nassschichtfilm aus. An diesen Schritt b) des Überlagerns schließt sich ein Härtungsschritt an.

In Figur 3b ist ein weiterer Überlagerungsschritt gezeigt. Hierbei wird der zweite Schichtaufbauvorläufer 22 gebildet. Dabei wird auf die gehärtete Metallschicht 3 wiederum durch ein gleichartig aufgebautes Sieb 10, wie in Figur 3a, wiederum eine Druckmasse 8 aus Schritt c) aufgebracht. Der Schichtaufbauvorläufer 22 weist nun einen Nassschichtfilm aus einer Druckmasse 8 auf. An diesen Schritt schließt sich wiederum ein Härtungsschritt an, wie für den ersten Schichtaufbauvorläufer 20 aus Figur 3a beschrieben.

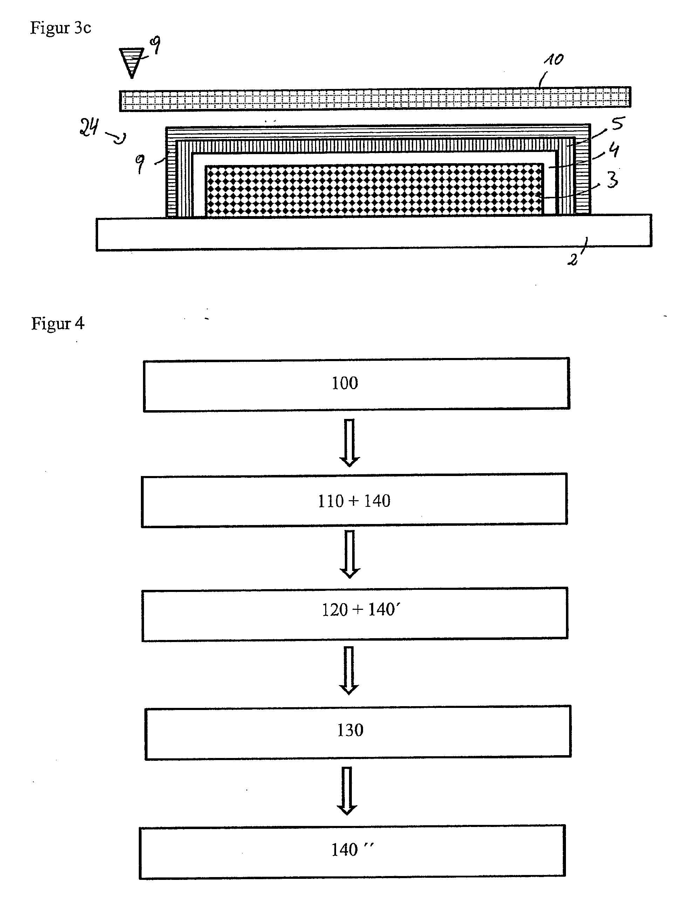

In Figur 3c wird ein Schichtaufbauvorläufer 24 gebildet. Hierbei wird auf den gehärteten Schichtaufbauvorläufer 22 eine Druckmasse 9 durch ein Sieb 10, wie in Figur 3a ausgestaltet, mit einer Rakel, wie oben beschrieben, aufgegeben. Dieser Schichtaufbauvorläufer 24 wird ebenfalls erhitzt, sodass ein erfindungsgemäßer Schichtaufbau 1 aus Figur 1 erhalten wird.

Figur 4 zeigt schematisch den Ablauf der erfindungsgemäßen Verfahrensschritte. In Schritt a) 100 wird eine Keramikschicht 2, in Form einer Al₂O₃-Schicht bereitgestellt. Auf die Keramikschicht 2 wird in Schritt b) 110 wie bereits zu Figur 3 a beschrieben eine Druckmasse aufgegeben. Der erhaltene Schichtaufbauvorläufer 20 wird in einem anschließenden Härtungsschritt, wie zuvor beschrieben gehärtet. Es entsteht eine Metallschicht 3 an der Oberfläche des Zwischenproduktes.

In Schritt 120 wird wiederum die Metallschicht 3 durch eine weitere Metallschicht 4 überlagert. Dabei wird eine Druckmasse 8 auf die Metallschicht 3 gegeben. So entsteht der Schichtaufbauvorläufer 22. Dieser wird anschließend in Schritt 140'gehärtet. Es entsteht die weitere Metallschicht 4.

Auf den gehärteten Schichtaufbauvorläufer 22 wird in Schritt 130 die zusätzliche Metallschicht 5 in Form der Druckmasse 8 aufgebracht. Dies geschieht ebenfalls bevorzugt über ein Sieb 10, wie in den Figuren 3a bis 3c gezeigt. Anschließend fmdet wiederum die Härtung der Druckmasse 8 zu der zusätzlichen Metallschicht 5 statt. Dieser Schritt 130 kombiniert mit Schritt 140' ist optional.

Auf die weitere Metallschicht 4 oder, wenn vorhanden die zusätzliche Metallschicht 5 wird nun in Schritt 130 eine Druckmasse 9 in Form einer Druckmasse über ein Sieb aufgebracht. Diese Druckmasse wird in Schritt 140'" gehärtet sodass ein Schichtaufbau 1, wie in Figur 1 gezeigt entsteht.

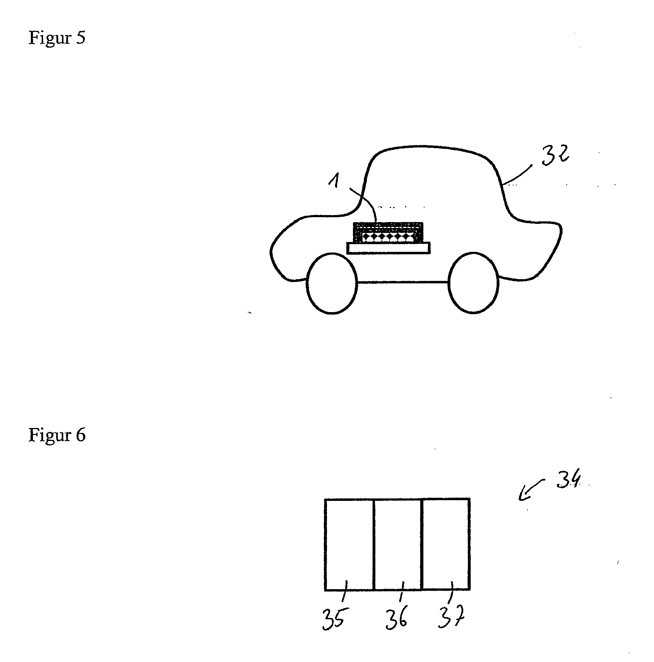

Die Figur 5 zeigt einen erfindungsgemäßen Schichtaufbau in einem Fahrzeug 30.

In Figur 6 ist schematisch ein Kit mit drei verschiedenen Pasten 35, 36, 37 gezeigt. Die erste Paste 35 enthält eine metallorganische Verbindung eines Metalls aus der VIII. Nebengruppe zur Ausbildung einer weiteren Metallschicht, wie sie zuvor für die Figuren 3 beschrieben wurde. Die zweite Paste 36 enthält eine metallorganische Verbindung eines Metalls aus der VIII: Nebengruppe zur Ausbildung einer zusätzlichen Metallschicht, wie sie ebenfalls zuvor beschrieben wurde und die dritte Paste 37 enthält eine metallorganische Verbindung aus einem Metall ausgewählt aus der Gruppe bestehend aus Palladium, Platin, Ruthenium, Rhodium, Silber und Gold , wie ebenfalls zuvor beschrieben. Die Pasten 35, 36, 37, sind in einem Kit 34 zusammengefasst. Es ist auch denkbar die Pasten 36 und 37 separat in einem Kit 34 zusammen zu fassen oder die Pasten 35 und 37 oder die Pasten 35 und 36 jeweils in einem Kit 34 zusammen zu fassen. Das Kit 34 kann darüber hinaus noch weitere Utensilien beinhalten, wie beispielsweise ein Sieb und eine Rakel, zum leichteren Applizieren der Pasten 35, 36, 36 (hier nicht gezeigt).

Rasterelektronenmikroskopische Aufnahmen der Oberflächen von erfindungsgemäß gehärteten Proben, die mit dem erfindungsgemäßen Verfahren hergestellt wurden, zeigten entweder glatte, nahezu strukturlose Flächen, in Figur 7a gezeigt, oder wabenförmige Strukturen, die zum Teil unregelmäßig sein können, und einen Durchmesser kleiner 3 µm aufweisen, wie in Figur 7b gezeigt. Der Schichtaufbau aus Figur 7a wurde gemäß Beispiel 2.1 a, wie oben beschrieben, hergestellt. Der Schichtaufbau aus Figur 7b wurde gemäß Beispiel 3.1 a, wie oben beschrieben, hergestellt.

Rasterelektronenmikroskopische Aufnahmen von Proben, die nach dem ENEPIG-Verfahren (Electroless Nickel Electroless Palladium Immersion Gold, genauer dem CeraBond M Prozess von Atotech) hergestellt wurden zeigten dagegen grob strukturierte Oberflächen. Die Struktur bestand aus unregelmäßigen wabenförmigen Gebilden mit einem Durchmesser von etwa 5-10 µm, die durch eine gut sichtbare Grenze voneinander getrennt waren. Diese Struktur einer solchen Oberfläche ist in Figur 7c dargestellt.

### Bezugszeichenliste

- 1: Schichtaufbau
- 2: Keramikschicht
- 3: Erste Metallschicht
- 4: Weitere Metallschicht
- 5: Zusätzliche Metallschicht
- 6: Äußere Schicht
- 7: Druckmasse Schritt b)
- 8: Druckmasse Schritt c)
- 9: Druckmasse Schritt d)
- 10: Sieb
- 12: Erster elektrischer Leiter
- 14: Zweiter elektrischer Leiter
- 16: Integrierter Schaltkreis (IC)
- 18: Elektrischer Kontakt
- 19: Metallschichtengruppe
- 20: Erster Vorläufer
- 22: Zweiter Vorläufer
- 24: Dritter Vorläufer
- 30: Elektrisches Bauteil
- 32: Fahrzeug
- 34: Kit
- 35: Erste Paste
- 36: Zweite Paste
- 37: Dritte Paste
- 100: Schritt a)
- 110: Schritt b)
- 120: Schritt c)
- 130: Schritt d)
- 140: Härtungsschritt
- 140': Härtungsschritt
- 140": Härtungsschritt

## Patentansprüche

1. Ein Verfahren zur Herstellung eines Schichtaufbaus (1), beinhaltend die Schritte:
a) Bereitstellen einer Keramikschicht (2) mit einer die Keramikschicht (2) mindestens teilweise überlagernden ersten Metallschicht (3);
b) mindestens teilweises Überlagern der ersten Metallschicht (3) mit einer weiteren Metallschicht (4), beinhaltend mindestens ein Metall der VIII. Nebengruppe;
c) gegebenenfalls mindestens teilweises Überlagern der ersten Metall-Schicht (3) mit einer zusätzlichen Metallschicht (5), beinhaltend mindestens ein Metall der VIII. Nebengruppe;
d) mindestens teilweises Überlagern der weiteren Metallschicht (4) oder der zusätzlichen Metallschicht (5) mit einer äußeren Schicht (6), beinhaltend mindestens ein Metall ausgewählt aus der Gruppe bestehend aus Palladium, Platin, Ruthenium, Rhodium, Silber und Gold oder mindestens zwei davon;
wobei das Überlagern in mindestens einem der Schritte b) bis d) durch Drucken mittels einer flüssigen Druckmasse (7, 8, 9) erfolgt, wobei die flüssige Druckmasse (7, 8, 9) eine metallorganische Verbindung in einer Menge in einem Bereich von 5 bis 50 Gew.-%, jeweils bezogen auf die Druckmasse (7, 8, 9) beinhaltet.

2. Das Verfahren nach Anspruch 1, wobei während des Druckens in den Schritten b) bis d) die Druckmasse (7, 8, 9) durch ein Sieb (10) aufgetragen wird.

3. Das Verfahren nach Anspruch 2 wobei das Sieb (10) eine Maschenweite in einem Bereich von 1 bis 300 µm aufweist.

4. Das Verfahren nach einem der vorhergehenden Ansprüche, wobei die metallorganische Verbindung eine organische Komponente ausgesucht aus der Gruppe bestehend aus einem Carbonat, einem Oxalat, einem Ester, einem Carboxylat, einem Halogencarboxylat, einem Hydroxycarboxylat, einem Acetonat, einem Ketonat, einem Phosphat, einem Phosphit, einem Phosphid, einem Phosphan, einem Sulfonat und einem Sulforesinat oder einer Mischung aus mindestens zwei davon aufweist.

5. Das Verfahren nach einem der vorhergehenden Ansprüche, wobei die erste Metallschicht (3) ein Metall beinhaltet, ausgewählt aus der Gruppe bestehend aus Silber und Kupfer oder einer Mischung daraus.

6. Das Verfahren nach einem der vorhergehenden Ansprüche, wobei die Druckmasse (7, 8, 9) als Massenkomponenten neben
v. der metallorganischen Verbindung,
mindestens eine weitere Komponente ausgewählt aus der Gruppe bestehend aus
vi. einem Lösemittel,
vii. einem organischen Additiv, und
viii. einem anorganischen Additiv,
oder mindestens zweien davon,
beinhaltet.

7. Das Verfahren nach einem der vorhergehenden Ansprüche, wobei das Metall der VIII. Nebengruppe ausgewählt ist aus der Gruppe bestehend aus Nickel, Palladium und Platin oder einer Mischung aus mindestens zwei davon.

8. Das Verfahren nach einem der vorhergehenden Ansprüche, wobei sich nach dem mindestens teilweisen Überlagern der ersten Metallschicht (3) oder der weiteren Metallschicht (4) oder der zusätzlichen Metallschicht (5) oder der äußeren Schicht (6) jeweils ein Härtungsschritt anschließt.

9. Das Verfahren nach einem der vorhergehenden Ansprüche, wobei mindestens ein Härtungsschritt teilweise in einer Gasatmosphäre mit einem Sauerstoffgehalt von weniger als 20 Vol.-% durchgeführt wird.

10. Das Verfahren nach dem vorhergehenden Anspruch, wobei während dem Härtungsschritt welcher teilweise in einer Gasatmosphäre mit einem Sauerstoffgehalt von weniger als 20 Vol.-% durchgeführt wird, die Temperatur, bei der der Wechsel der Atmosphäre stattfindet, in einem Bereich von 150 bis 400°C liegt.

11. Das Verfahren nach dem vorhergehenden Anspruch, wobei die erste Metallschicht (3) nach dem Härtungsschritt eine Dicke in einem Bereich von 1 bis 500 µm aufweist.

12. Das Verfahren nach einem der Ansprüche 7 bis 11, wobei die weitere Metallschicht (4) oder die zusätzliche Metallschicht (5) oder beide nach dem Härtungsschritt jeweils eine Dicke in einem Bereich von 0,01 bis 20 µm aufweist.

13. Das Verfahren nach einem der Ansprüche 7 bis 12, wobei die äußere Schicht (6) nach dem Härtungsschritt jeweils eine Dicke in einem Bereich von 0,01 bis 1 µm aufweist.

14. Das Verfahren nach einem der Ansprüche 7 bis 13, wobei die erste Metallschicht (3) nach dem Härtungsschritt einen auf eine Schichtdicke von 12 µm normierten Flächenwiderstand in einem Bereich von 0,1 bis 10 mOhm/sq aufweist.

15. Das Verfahren nach einem der Ansprüche 7 bis 14, wobei der Schicht-Aufbau (1) nach dem Härtungsschritt einen auf eine Schichtdicke von 12 µm normierten Flächenwiderstand in einem Bereich von 0,1 bis 10 mOhm/sq aufweist.

16. Das Verfahren nach einem der vorhergehenden Ansprüche, wobei die äußere Schicht (6) mit einem elektrischen Leiter (12, 14) verbunden wird.

17. Das Verfahren nach dem vorhergehenden Anspruch, wobei der elektrische Leiter (12, 14) ein Metall beinhaltet, ausgewählt aus der Gruppe bestehend aus Aluminium, Eisen, Gold, Platin, Palladium, Kupfer und Silber oder mindestens zwei davon.

18. Ein Schichtaufbau (1) beinhaltend folgende Schichtabfolge:
■ eine Keramikschicht (2);
■ mindestens eine Metallschichtengruppe (19) mit einer Schichtabfolge:
● eine erste Metallschicht (3);
● eine weitere Metallschicht (4);
● gegebenenfalls eine zusätzliche Metallschicht (5);
● eine äußere Schicht (6).

19. Der Schichtaufbau (1) nach Anspruch 18, wobei die erste Metallschicht (3) ein Metall beinhaltet, ausgewählt aus der Gruppe bestehend aus Silber und Kupfer oder einer Mischung daraus.

20. Der Schichtaufbau (1) nach Anspruch 18 oder 19, wobei der Schichtaufbau (1) mindestens eine der folgenden Eigenschaften aufweist:
e1. die Dicke der ersten Metallschicht (3) liegt in einem Bereich von 1 bis 500 µm, die Dicke der weiteren Metallschicht (4) liegt in einem Bereich von 0,1 bis 20 µm, die Dicke der zusätzlichen Metallschicht (5) liegt in einem Bereich von 0,05 bis 10 µm und die Dicke der äußeren Schicht (6) liegt in einem Bereich von 0,01 bis 1 µm;
e2. die Dicke der Schichten (3, 4, 5, 6,) nimmt von der ersten Metallschicht (3) über die weitere Metallschicht (4), gefolgt von der zusätzliche Metallschicht (5) zur äußeren Schicht (6) hin ab;
e3. der Kontaktwinkel der Oberfläche der äußeren Schicht (6) gegenüber reinem Wasser liegt in einem Bereiche von 70 bis 100°.;

21. Der Schichtaufbau (1) nach Anspruch 18, 19 oder 20, wobei der Schichtaufbau (1) mindestens eine der folgenden Eigenschaften aufweist:
e4. das Verhältnis der Schichtdicken der ersten Metallschicht (3) zur weiteren Metallschicht (4) in einem Bereich von 1:1 bis 1:150 liegt;
e5. das Verhältnis der Schichtdicken der zusätzlichen Metallschicht (5) zur weiteren Metallschicht (4) in einem Bereich von 10:1 1 bis 1:1 1 liegt;
e6. das Verhältnis der Schichtdicken der äußeren Schicht (6) zur weiteren Metallschicht (4) in einem Bereich von 3:1 bis 10:1 liegt.

22. Ein erster Schichtaufbauvorläufer (20) erhältlich nach einem Verfahren nach einem der Ansprüche 1 bis 7, wobei der erste Schichtaufbauvorläufer (20) die Keramikschicht (2) und die erste Metallschicht (3) mit einer Dicke in einem Bereich von 1 bis 500 µm beinhaltet sowie die weitere Metallschicht (4) in Form einer flüssigen Druckmasse (7), wobei der erste Schichtaufbauvorläufer (20) mindestens eine der folgenden Eigenschaften aufweist:
EP1 die Dicke der Druckmasse der weiteren Metallschicht (4) liegt in einem Bereich von 4 bis 25 µm Nassschichtdicke;
EP2 die Viskosität der Druckmasse (7) für die weitere Metallschicht (4) liegt in einem Bereich von 500 bis 50000 mPas.

23. Ein zweiter Schichtaufbauvorläufer (22) erhältlich nach einem Verfahren nach einem der Ansprüche 1 bis 10, wobei der zweite Schichtaufbauvorläufer (22) die Keramikschicht (2) und die erste Metallschicht (3) mit einer Dicke in einem Bereich von 1 bis 500 µm beinhaltet sowie die gehärtete weitere Metallschicht (4) mit einer Dicke in einem Bereich von 0,1 bis 20 µm und die zusätzliche Metallschicht (5) in Form einer flüssigen Druckmasse (8), wobei der zweite Schichtaufbauvorläufer (22) mindestens eine der folgenden Eigenschaften aufweist:
EP3 die Dicke der Druckmasse für die zusätzliche Metallschicht (5) liegt in einem Bereich von 4 bis 25 µm Nassschichtdicke;
EP4 die Viskosität der Druckmasse (8) für die zusätzliche Metallschicht (5) liegt in einem Bereich von 500 bis 50000 mPas.

24. Ein dritter Schichtaufbauvorläufer (24) erhältlich nach einem Verfahren nach einem der Ansprüche 1 bis 10, wobei der dritte Schichtaufbauvorläufer (24) die Keramikschicht (2), die erste Metallschicht (3) mit einer Dicke in einem Bereich von 1 bis 500 µm, die gehärtete weitere Metallschicht (4) mit einer Dicke in einem Bereich von 0,01 bis 20 µm und die gehärtete zusätzliche Metallschicht (5) mit einer Dicke in einem Bereich von 0,05 bis 10 µm beinhaltet sowie die äußere Schicht (6) in Form einer flüssigen Druckmasse (9), wobei der dritte Schichtaufbauvorläufer (24) mindestens eine der folgenden Eigenschaften aufweist:
EP5 die Dicke der Druckmasse für die äußere Schicht (6) liegt in einem Bereich von 4 bis 30 µm Nassschichtdicke;
EP6 die Viskosität der Druckmasse (9) für die äußere Schicht (6) liegt in einem Bereich von 500 bis 50000 mPas.

25. Ein Schichtaufbau (1) erhältlich nach einem Verfahren nach einem der Ansprüche 8 bis 17, wobei der Schichtaufbau (1) mindestens eine der folgenden Eigenschaften aufweist:
ES 1 einen Kontaktwinkel der Oberfläche der äußeren Schicht (6) gegenüber destilliertem Wasser liegt in einem Bereiche von 70 bis 100°;
ES2 die Dicke der ersten Metallschicht (3) liegt in einem Bereich von 1 bis 500 µm, die Dicke der weiteren Metallschicht (4) liegt in einem Bereich von 0,01 bis 20 µm, die Dicke der zusätzlichen Metallschicht (5) liegt in einem Bereich von 0,05 bis 10 µm und die Dicke der äußeren Schicht (6) liegt in einem Bereich von 0,01 bis 1 µm;
ES3 die Dicke der Schichten (3, 4, 5, 6) nimmt von der ersten Metallschicht (3) über die weitere Metallschicht (4), gefolgt von der zusätzlichen Metallschicht (5) zur äußeren Schicht (6) hin ab.

26. Ein elektrisches Bauteil (30) beinhaltend einen integrierten Schaltkreis (16) und einen Schichtaufbau (1) nach einem der Ansprüche 18, 19, 20, 21 oder 25.

27. Das elektrische Bauteil (30) nach Anspruch 26, wobei der integrierte Schaltkreis (16) über einen ersten elektrischen Leiter (12) mit dem Schichtaufbau (1) verbunden ist und der Schichtaufbau (1) über einen zweiten elektrischen Leiter (14) mit einem weiteren elektrischen Bauteil (18) verbunden ist.

28. Das elektrische Bauteil (30) nach Anspruch 27, wobei der erste elektrische Leiter (12) ein edleres Metall beinhaltet als der zweite elektrische Leiter (14).

29. Ein Fahrzeug (32) beinhaltend ein elektrisches Bauteil (30) nach einem der Ansprüche 26 bis 28.

30. Kit (34) beinhaltend:
i. eine erste Paste (35), beinhaltend mindestens zu einem Teil eine erste metallorganische Verbindung, beinhaltend mindestens ein Metall der VIII. Nebengruppe;
ii. eine zweite Paste (36) beinhaltend mindestens zu einem Teil eine weitere metallorganische Verbindung, beinhaltend mindestens ein Metall der VIII: Nebengruppe;
iii. eine dritte Paste (37), beinhaltend mindestens zu einem Teil eine dritte metallorganische Verbindung, beinhaltend ein Metall ausgewählt aus der Gruppe bestehend aus Palladium, Platin, Ruthenium, Rhodium, Silber und Gold oder mindestens zwei hiervon.
